(19) Europäisches Patentamt
European Patent Office
Office européen des brevets

(11) EP 1 933 397 A1

(12) **EUROPEAN PATENT APPLICATION**
published in accordance with Art. 153(4) EPC

(43) Date of publication:
**18.06.2008 Bulletin 2008/25**

(21) Application number: **07743779.6**

(22) Date of filing: **21.05.2007**

(51) Int Cl.:
***H01L 51/50*** *(2006.01)* ***H05B 33/12*** *(2006.01)*

(86) International application number:
**PCT/JP2007/060345**

(87) International publication number:
**WO 2007/138906 (06.12.2007 Gazette 2007/49)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **25.05.2006 JP 2006145983**
**25.05.2006 JP 2006146001**
**27.06.2006 US 475081**
**27.06.2006 US 475225**

(71) Applicant: **Idemitsu Kosan Co., Ltd.**
**Chiyoda-ku**
**Tokyo 100-8321 (JP)**

(72) Inventors:
- **JINDE, Yukitoshi**
  **Sodegaura-shi, Chiba 299-0293 (JP)**
- **KUMA, Hitoshi**
  **Sodegaura-shi, Chiba 299-0293 (JP)**
- **IKEDA, Kiyoshi**
  **Sodegaura-shi, Chiba 299-0293 (JP)**
- **ITO, Mitsunori**
  **Sodegaura-shi, Chiba 299-0293 (JP)**

(74) Representative: **Gille Hrabal Struck Neidlein Prop Roos**
**Patentanwälte**
**Brucknerstrasse 20**
**40593 Düsseldorf (DE)**

# (54) ORGANIC ELECTROLUMINESCENT DEVICE AND FULL COLOR LIGHT-EMITTING DEVICE

(57) An organic electroluminescence device (10) including: an anode (1), a first emitting layer (3), a carrier blocking layer (4), a second emitting layer (5), and a cathode (7) stacked in that order; the first emitting layer (3) and the second emitting layer (5) each containing a host material and a dopant; the energy gap of the host material of the first emitting layer (3) being smaller than the energy gap of the host material of the second emitting layer (5); the host material of the first emitting layer (3) being a hole transporting material, and the host material of the second emitting layer (5) being an electron transporting material; the affinity level of the carrier blocking layer (4) being smaller than the affinity level of the host material of the second emitting layer (5) in an amount of 0.2 eV or more; and the ionization potential (Ie1) of the carrier blocking layer (4) and the ionization potential (Ih1) of the host material of the first emitting layer (3) satisfying the following relationship (1):

$$Ie1 < Ih1 + 0.1 \ (eV) \qquad (1)$$

FIG. 1

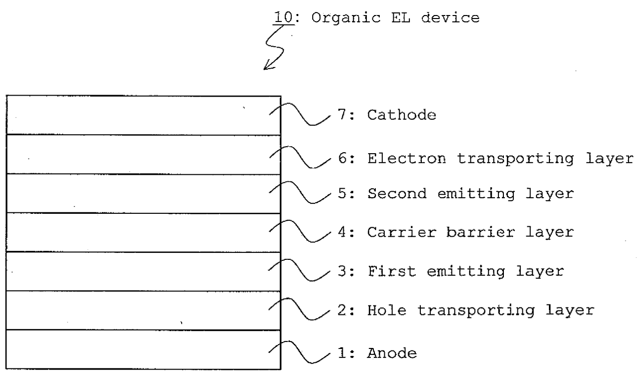


EP 1 933 397 A1

## Description

TECHNICAL FIELD

The invention relates to an organic electroluminescence device and a full-color light-emitting apparatus obtained using the same.

BACKGROUND

Recently, white organic electroluminescence (EL) devices are being briskly developed because they can be used for mono-color display devices, lighting applications such as back lights, and full-color displays with color filters. In the case where white organic EL devices are used for lighting applications, they are required to have a high luminous efficiency, for example, which is equivalent to or more than that of fluorescent lamps.

Many methods of producing white light emission by an organic EL device have been disclosed. Few of the methods produce white light with only one kind of emitting material and a single organic EL device generally uses two or three kinds of emitting materials that emit light simultaneously. In the case of using two kinds of emitting materials, a blue emitting material and a yellow-to-red emitting material, yellow-to-red being the complementary color to blue, are selected. However, the yellow-to-red light emission becomes dominant in many cases, thereby yielding a reddish white color.

Patent document 1 proposes a white device in the type where an emitting layer is divided into two layers, the emission zone of which tends to be localized to the anode side. The tendency for red to be stronger in color of emitted light is negated by using a blue emitting layer as an emitting layer on the anode side, and whose color change is suppressed. The level of the luminous efficiency was, however, not necessarily enough.

Patent document 2 discloses an organic EL device in which a red emitting layer, a blue emitting layer, and a green emitting layer are stacked in that order from the anode side. Patent document 2 also discloses technology of reducing a change in color due to an increase in driving current by doping the blue emitting layer with a red dopant used for the red emitting layer. However, the luminous efficiency of this organic EL device is not necessarily satisfactory.

As technology of obtaining white light in a well-balanced manner, technologies of providing a carrier blocking layer between emitting layers have been disclosed.

For example, Patent document 3 discloses an organic EL device which emits white light and in which an anode, a hole transporting blue emitting layer, an electron transporting carrier recombination region control layer, an electron transporting red emitting layer, and a cathode are stacked in that order. However, since the affinity level of the carrier recombination region control layer is larger than the affinity level of the hole transporting blue emitting layer, the organic EL device requires a high driving voltage. Moreover, since electrons are injected into the hole transporting blue emitting layer to a smaller extent as the driving time increases, the emission intensity of the hole transporting blue emitting layer decreases, whereby the emission color tends to be biased to the red light from the electron transporting emitting layer.

Patent document 4 discloses a white organic EL device in which two electron transporting emitting layers are disposed through a carrier blocking layer. However, since holes injected from the anode are almost completely consumed by the first emitting layer, only a small number of holes are supplied to the second electron transporting emitting layer through the carrier blocking layer. As a result, white luminous efficiency is decreased.

Patent document 5 discloses a white organic EL device in which an anode, first emitting layer, carrier blocking layer, second emitting layer, and cathode are stacked in that order, wherein the ionization potential of the carrier blocking layer is greater than the ionization potential of the first emitting layer in an amount of 0.1 eV or more, and the affinity level of the carrier blocking layer is smaller than the affinity level of the second emitting layer in an amount of 0.1 eV or more. However, since the carrier blocking layer has both electron blocking and hole blocking functions, the driving voltage is increased.

In addition to the above, white organic EL devices are disclosed also in Patent documents 6 and 7. However, the luminous efficiency thereof is insufficient.

[Patent document 1] JP-A-2003-272857
[Patent document 2] JP-A-2004-235168
[Patent document 3] JP-A-8-78163
[Patent document 4] WO2005/099313
[Patent document 5] WO2005/112518
[Patent document 6] JP-A-2005-100921
[Patent document 7] US-A-2006/0088729

In view of the above-described problems, an object of the invention is to provide an organic EL device which exhibits color rendition suitable for displays and lighting applications, exhibits high luminous efficiency, and shows a small change in chromaticity.

DISCLOSURE OF THE INVENTION

The inventors of the invention have conducted extensive studies in order to achieve the above object. As a result, the inventors found that the following organic EL device exhibits high color rendition and high luminous efficiency and shows a small change in chromaticity. These findings have led to the completion of the invention.

The invention provides the following organic EL device and full-color emitting apparatus.

1. An organic electroluminescence device comprising:

an anode, a first emitting layer, a carrier blocking layer, a second emitting layer, and a cathode stacked in that order;
the first emitting layer and the second emitting layer each containing a host material and a dopant;
the energy gap of the host material of the first emitting layer being smaller than the energy gap of the host material of the second emitting layer;
the host material of the first emitting layer being a hole transporting material, and the host material of the second emitting layer being an electron transporting material;
the affinity level of the carrier blocking layer being smaller than the affinity level of the host material of the second emitting layer by 0.2 eV or more; and
the ionization potential (Ie1) of the carrier blocking layer and the ionization potential (Ih1) of the host material of the first emitting layer satisfying the following relationship (1):

$$Ie1<Ih1+0.1\ (eV) \qquad (1)$$

2. An organic electroluminescence device comprising:

an anode, a first emitting layer, a carrier blocking layer, a second emitting layer, a third emitting layer, and a cathode stacked in that order;
the first emitting layer, the second emitting layer and the third emitting layer each containing a host material and a dopant;
the energy gap of the host material of the first emitting layer being smaller than the energy gap of the host material of the second emitting layer;
the host material of the first emitting layer being a hole transporting material;
the host materials of the second and third emitting layers being electron transporting materials;
the carrier blocking layer being a hole transporting material; and
the ionization potential (Ie1) of the carrier blocking layer and the ionization potential (Ih1) of the host material of the first emitting layer satisfying the following relationship (1):

$$Ie1<Ih1+0.1\ (eV) \qquad (1)$$

3. The organic electroluminescence device according to 2, wherein the affinity level of the carrier blocking layer is smaller than the affinity level of the host material of the second emitting layer in an amount of 0.2 eV or more.

4. The organic electroluminescence device according to any one of 1 to 3, wherein the energy gap of the host material of the first emitting layer is smaller than the energy gap of the host material the second emitting layer in an amount of 0.4 eV or more.

5. The organic electroluminescence device according to 1, wherein the dopant of the first emitting layer is a red dopant and the dopant of the second emitting layer is a blue dopant.

6. The organic electroluminescence device according to 2 or 3, wherein the dopant of the first emitting layer is a red dopant and the dopant of the second emitting layer is a blue dopant, and the dopant of the third emitting layer is a green dopant.

7. The organic electroluminescence device according to any one of 1 to 6, wherein the carrier blocking layer includes an emitting material.

8. The organic electroluminescence device according to 7, wherein the emitting material of the carrier blocking layer is a green dopant.

9. The organic electroluminescence device according to any one of 1 to 8, further comprising a hole transporting layer adjacent to the first emitting layer between the anode and the first emitting layer.

10. The organic electroluminescence device according to 9, wherein a material forming the hole transporting layer is the same as a material forming the carrier blocking layer.

11. The organic electroluminescence device according to any one of 1 to 10, wherein the first emitting layer or a first organic layer which is the organic layer closer to the anode comprises an oxidizing agent and/or the second emitting layer or a second organic layer which is the organic layer closer to the cathode comprises a reducing agent.

12. An organic electroluminescence device according to any one of 1 to 11, wherein the host material of the first emitting layer is a compound represented by the following formula (1), and a dopant of the first emitting layer is a compound containing a fluoranthene skeleton or a perylene skeleton;

$$X-(Y)_n \qquad (1)$$

wherein X is a condensed aromatic ring group with 3 or more carbocycles,

Y is a group selected from a substituted or unsubstituted aryl group, a substituted or unsubstituted diarylamino group, a substituted or unsubstituted arylalkyl group and a substituted or unsubstituted alkyl group, and
n is an integer of 1 to 6, provided that Ys may be the same or different when n is 2 or more.

13.The organic electroluminescence device according to 12, wherein the compound containing a fluoranthene skeleton or a perylene skeleton is an indenoperylene derivative of the following formula (2) or (3);

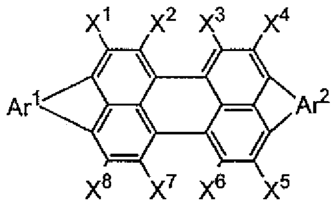
(2)

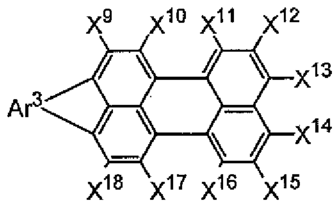
(3)

wherein $Ar^1$, $Ar^2$ and $Ar^3$ are each a substituted or unsubstituted aromatic ring group or substituted or unsubstituted aromatic heterocyclic group; $X^1$ to $X^{18}$ are each a hydrogen atom, halogen atom, alkyl group, alkoxy group, alkylthio group, alkenyl group, alkenyloxy group, alkenylthio group, aromatic-ring-containing alkyl group, aromatic-ring-containing alkyloxy group, aromatic-ring-containing alkylthio group, aromatic ring group, aromatic heterocyclic group, aromatic ring oxy group, aromatic ring thio group, aromatic ring alkenyl group, alkenyl aromatic ring group, amino group, carbazolyl group, cyano group, hydroxyl group, $-COOR^{1'}$ ($R^{1'}$ is a hydrogen atom, alkyl group, alkenyl group, aromatic-ring-containing alkyl group, or aromatic ring group), $-COR^{2'}$ ($R^{2'}$ is a hydrogen atom, alkyl group, alkenyl group, aromatic-ring-containing alkyl group, aromatic ring group or amino group) or $-OCOR^{3'}$ ($R^{3'}$ is an alkyl group, alkenyl group, aromatic-ring-containing alkyl group or aromatic ring group); and adjacent groups of $X^1$ to $X^{18}$ may be bonded to each other to form a ring with a substituted carbon atom.

14.The organic electroluminescence device according to 13, wherein the indenoperylene derivative is a dibenzotetraphenylperiflanthene derivative.

15. The organic electroluminescence device according to any one of claims 12 to 14, wherein the number of condensed rings in the host material of the first emitting layer is 4 or more and the number of condensed rings in the host material of the second emitting layer is 3 or less.

16. The organic electroluminescence device according to any one of 12 to 15, wherein the compound of the formula (1) is a naphthacene derivative of the following formula (4);

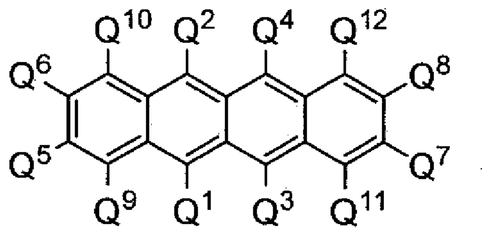

(4)

wherein $Q^1$ to $Q^{12}$, which may be the same or different, are independently a hydrogen atom, a substituted or unsubstituted alkyl group having 1 to 20 carbon atoms that form a ring, a substituted or unsubstituted aryl group having 6 to 20 carbon atoms that form a ring, an amino group, a substituted or unsubstituted alkoxy group having 1 to 20 carbon atoms, a substituted or unsubstituted alkylthio group having 1 to 20 carbon atoms, a substituted or unsubstituted aryloxy group having 6 to 20 carbon atoms, a substituted or unsubstituted arylthio group having 6 to 20 carbon atoms that form a ring, a substituted or unsubstituted alkenyl group having 2 to 20 carbon atoms, a substituted or unsubstituted aralkyl group having 7 to 20 carbon atoms that form a ring or a substituted or unsubstituted heterocyclic group having 5 to 20 atoms that form a ring.

17. The organic electroluminescence device according to 16, wherein at least one of $Q^1$, $Q^2$
, Q3 and Q4 in the naphthacene derivative of formula (4) is an aryl group.

18.The organic electroluminescence device according to 17, wherein the naphthacene derivative of formula (4) is represented by the following formula (5):

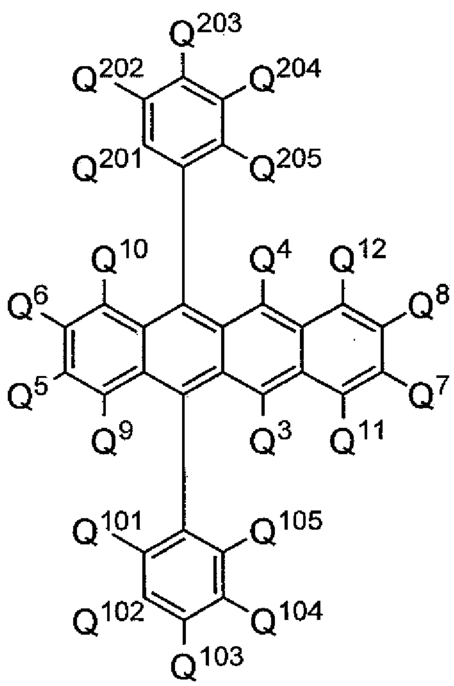

(5)

wherein $Q^3$ to $Q^{12}$, $Q^{101}$ to $Q^{105}$, and $Q^{201}$ to $Q^{205}$, which may be the same or different, are independently the same groups as those mentioned for $Q^3$ to $Q^{12}$ in said formula (1), and adjacent two or more thereof may be bonded to each other to form a ring.

19. The organic electroluminescence device according to 18, wherein at least one of $Q^{101}$, $Q^{105}$, $Q^{201}$ and $Q^{205}$ of the napthacene derivative of the formula (5) is an alkyl group, an aryl group, an amino group, an alkoxy group, an aryloxy group, an alkylthio group, an arylthio group, an alkenyl group, an aralykyl group or a heterocyclic group, which may be the same or different.

20. The organic electroluminescence device according to any one of 12 to 19, wherein the carrier blocking layer contains a tertiary amine compound, a carbazole derivative, a nitrogen-containing heterocyclic group or a metal complex.

21. A full-color emitting apparatus comprising the organic electroluminescence device according to any one of 1 to 20 that emits white light and a color filter.

According to the invention, an organic EL device can be provided which exhibits color rendition and high luminous efficiency and shows only a small change in chromaticity.

## BRIEF DESCRIPTION OF THE DRAWINGS

FIG. 1 is a view showing a configuration of an organic EL device according to a first embodiment of the invention.
FIG. 2 is a view showing the energy levels of a first emitting layer, a carrier blocking layer, and a second emitting layer of the organic EL device shown in FIG. 1.
FIG. 3 is a view showing a configuration of an organic EL device according to a second embodiment of the invention.
FIG. 4 is a view showing a configuration of an organic EL device according to a third embodiment of the invention.
FIG. 5 is a view showing the energy levels of a first emitting layer, first carrier blocking layer, and second emitting layer formed in Example 1.
FIG. 6 is a view showing the energy levels of a first emitting layer, first carrier blocking layer, and second emitting layer formed in Comparative Example 4.
FIG. 7 is a view showing the energy levels of a first emitting layer, first carrier blocking layer, and second emitting layer formed in Comparative Example 5.
FIG. 8 is a view showing the CIE1931 chromaticity coordinate x for the luminance of organic EL devices fabricated in Comparative Example 1 and Examples 1 to 4.
FIG. 9 is a view showing the CIE1931 chromaticity coordinate y for the luminance of organic EL devices fabricated in Comparative Example 1 and Examples 1 to 4.

## BEST MODE FOR CARRYING OUT THE INVENTION

### First embodiment

The organic EL device of the first embodiment of the invention comprises an anode, a first emitting layer, a carrier blocking layer, a second emitting layer, and a cathode that are stacked in that order. The first emitting layer and the second emitting layer each contain a host material and a dopant.
The first emitting layer contains a hole transporting material as the host material, and the second emitting layer contains an electron transporting material as the host material. Furthermore, the energy gap of the host material of the first emitting layer is smaller than the energy gap of the host material of the second emitting layer.
In addition, the affinity level of the carrier blocking layer is smaller than the affinity level of the host material of the second emitting layer in an amount of 0.2 eV or more. The ionization potential (Ie1) of the carrier blocking layer and the ionization potential (Ih1) of the host material of the first emitting layer satisfy the following relationship (1).

$$Ie1 < Ih1 + 0.1 \text{ (eV)} \qquad (1)$$

Preferably, the affinity level of the carrier blocking layer (Afe1) is larger than 1 eV, and is smaller than the affinity

level of the host material of the second emitting layer (Afh2) in an amount of 0.2 eV or more (satisfying the following relationship):

$$1 < Afe1 \leqq Afh2 - 0.2 \, (eV)$$

Preferably, the ionization potential of the carrier blocking layer (Ie1) and the ionization potential of the host material of the first emitting layer (Ih1) satisfy the following relationship:

$$2.5 < Ie1 < Ih1 + 0.1 \, (eV)$$

Preferably, the energy gap of the host material of the first emitting layer (Egh1) is larger than 1.5 eV, and is smaller than the energy gap of the host material of the second emitting layer (Egh2) in an amount of 0.4 eV or more (satisfying the following relationship):

$$1.5 < Egh1 \leqq Egh2 - 0.4 \, (eV)$$

FIG. 1 is a view showing a configuration of an organic EL device according to a first embodiment of the invention. In the organic EL device 10 shown in FIG. 1, an anode 1, a hole transporting layer 2, a first emitting layer 3, a carrier blocking layer 4, a second emitting layer 5, an electron transporting layer 6 and a cathode 7 are stacked.
The first emitting layer 3 and the second emitting layer 5 each contain a host material and a dopant.
In this device 10, white emission can be obtained, for example, by using the first emitting layer 3 as a red emitting layer and the second emitting layer 5 as a blue emitting layer. Doping the second emitting layer 5 with a blue dopant is aimed at enhancing the blue emission, which is generally weak, to obtain white light with an excellent color balance.

In the organic EL device 10, the host material of the first emitting layer 3 on the anode 1 side is a hole transporting material, and the host material of the second emitting layer 5 on the cathode 7 side is an electron transporting material. Between the first emitting layer 3 and the second emitting layer 5, a carrier blocking layer 4 is provided. This allows injection of electrons into the first emitting layer 3 and injection of holes into the second emitting layer 5 in a well-balanced manner, and allows blocking of electrons by the carrier blocking layer 4, whereby the recombination zone is concentrated around the interface of the carrier blocking layer 4 and the second emitting layer. As a result, blue emission can be obtained efficiently since the second emitting layer 5 is doped with a blue dopant, and strong blue emission can be obtained although blue emission is generally weak. In the first emitting layer 3, electrons injected through the carrier blocking layer and holes injected from the anode are recombined and the energy of blue emission from the second emitting layer 5 is transferred to the first red emitting layer 3 to obtain red emission, whereby white light with an excellent color balance can be obtained with high efficiency.

The term "hole transporting" used in the invention means that the hole mobility of the layer is larger than the electron mobility thereof in the electric field range of $10^2$ to $10^8$ V/cm. The hole mobility of the first emitting layer is preferably $10^{-5}$ $cm^2/V \cdot sec$ or more.
The term "electron transporting" used in the invention means that the electron mobility of the layer is larger than the hole mobility thereof in the electric field range of $10^2$ to $10^8$ V/cm. The electron mobility of the second emitting layer is preferably $10^{-6}$ $cm^2/V \cdot sec$ or more.
The hole or electron mobility is measured using a time of flight method.

When the host materials of first and second emitting layers are electron transporting materials, the recombination zone is localized to the first emitting layer in the same manner as in Patent document 4, whereby it is difficult to obtain excellent white light.
On the other hand, when the host materials of first and second emitting layers are hole transporting materials, the recombination zone is localized to the second emitting layer, whereby it is difficult to obtain excellent white light. In the second emitting layer, the recombination zone tends to be localized to the cathode. Therefore, the luminous efficiency decreases due to the quenching effect of the metal cathode.
When the host material of the first emitting layer is an electron transporting material and the host material of the second emitting layer is a hole transporting material, injection of electrons into the first emitting layer and injection of holes into the second emitting layer are hindered, whereby a significant increase in the driving voltage occurs.
Now, consideration is made on a case shown in the Patent document 3, where an anode, a hole transporting blue

emitting layer, an electron transporting carrier recombination zone control layer, an electron transporting red emitting layer and a cathode are stacked in that order.

In this case, due to a large energy gap of a blue emitting material, the affinity level of the hole transporting blue emitting layer becomes low. In addition, the affinity level of the electron transporting recombination zone control layer is generally high. Therefore, the electron injection barrier from an electron transporting carrier recombination zone control layer to a hole transporting blue emitting layer becomes high. As a result, the device needs a high driving voltage as a whole.

In contrast, in the configuration of this embodiment, since the blue emitting layer is positioned on the cathode side of the carrier blocking layer, the gap in the affinity level does not increase excessively, thus preventing driving voltage from increasing.

In the organic EL device 10, the affinity level of the carrier blocking layer 4 is smaller than the affinity level of the host material of the second emitting layer 5 in an amount of 0.2 eV or more. The ionization potential (Ie1) of the carrier blocking layer 4 and the ionization potential (Ih1) of the host material of the first emitting layer 3 satisfy the following relationship (1).

$$Ie1<Ih1+0.1 \text{ (eV)} \qquad (1)$$

This relationship is described below using a diagram showing the energy level.

FIG. 2 shows the energy levels of the host material of the first emitting layer 3, the carrier blocking layer 4, and the host material of the second emitting layer 5 of the organic EL device 10. In FIG. 2, the level on the upper side indicates the affinity level of each layer, and the level on the lower side indicates the ionization potential. In the energy level diagram, the value increases downward. The difference between the ionization potential and the affinity level corresponds to the energy gap in each layer.

In the organic EL device 10, the affinity level of the carrier blocking layer 4 is smaller than the affinity level of the second emitting layer 5 in an amount of 0.2 eV or more. In FIG. 2, the affinity level of the carrier blocking layer 4 is positioned above the affinity level of the second emitting layer 5 in an amount of 0.2 eV or more ($\Delta Af_1$ in FIG. 2 is 0.2 eV or more).

The carrier blocking layer 4 is a layer which limits injection of electrons from the second emitting layer 5 on the cathode 7 side into the first emitting layer 3 on the anode 1 side, and is provided to control the amount of recombination of electron-hole pairs in each emitting layer to adjust the amount of light from each emitting layer. It is necessary for the carrier blocking layer 4 to have an affinity level smaller than the affinity level of the host material of the second emitting layer in an amount of 0.2 eV or more taking the above function into consideration. The carrier blocking layer 4 preferably has an affinity level smaller than the affinity level of the second emitting layer in an amount of 0.5 eV or more.

The relationship between the affinity level of the host material of the first emitting layer 3 and the affinity level of the carrier blocking layer 4 is not particularly limited. The carrier blocking layer 4 preferably has an affinity level smaller than the affinity level of the host material of the first emitting layer 3 in an amount of 0 eV or more.

In the organic EL device 10, the ionization potential (Ie1) of the carrier blocking layer 4 and the ionization potential (Ih1) of the host material of the first emitting layer 3 satisfy the above relationship (1). This aims at preventing a problem in which the carrier blocking layer 4 becomes a barrier for holes to increase the driving voltage.

The ionization potential (Ie1) of the carrier blocking layer 4 and the ionization potential (Ih1) of the host material of the first emitting layer 3 preferably satisfy the following expression (1'):

$$Ie1<Ih1-0.2 \text{ (eV)} \qquad (1')$$

In the organic EL device 10, the energy gap of the host material of the first emitting layer 3 is smaller than the energy gap of the host material of the second emitting layer 5, preferably in an amount of 0.4 eV or more. When the energy gap of the host material of the first emitting layer 3 is larger than the energy gap of the second emitting layer 5, or the energy gap of the first emitting layer 3 is smaller than the energy gap of the second emitting layer 5 in an amount of less than 0.4 eV, the difference in affinity level between the second emitting layer 5 and the carrier blocking layer 4 may become too large. As a result, the number of electrons supplied to the first emitting layer 3 may be too small, whereby excellent white light may not be obtained. In more detail, it is preferred that the energy gap of the host material of the first emitting layer 3 be 1.8 to 2.8 eV and the energy gap of the host material of second emitting layer 5 be 2.2 to 3.3 eV.

If the dopant in the first emitting layer is a red dopant and the dopant in the second emitting layer is a blue dopant, by allowing the first emitting layer 3 to emit red light and the second emitting layer 5 to emit blue light, and satisfying the above requirement, well-balanced white light can be obtained.

The reason for the fact that the energy gap of the host material of the first emitting layer is preferably smaller than the energy gap of the host material of the second emitting layer is not fully elucidated. However, the reason appears as follows:

Since blue is a color of which the emission is weak, the device is caused to emit light by generating excitons mainly in the blue emission region. For that reason, it is preferred that the blue emitting layer be positioned on the cathode side of the electron blocking layer and the red emitting layer be positioned on the anode side of the electron blocking layer. Due to such a configuration, excitons are generated in the second emitting layer (blue) located on the cathode side of the electron blocking layer, and strong blue emission can be obtained. As compared with the first emitting layer, the second emitting layer has a large energy gap, and the energy is transferred to the first emitting layer. As a result, the second emitting layer also emits red light.

The device configuration according to this embodiment is not limited to the configuration shown in FIG. 1. For example, the following configurations may also be employed.

1. Anode/first emitting layer/carrier blocking layer/second emitting layer/cathode
2. Anode/hole transporting layer/first emitting layer/carrier blocking layer/second emitting layer/cathode
3. Anode/first emitting layer/carrier blocking layer/second emitting layer/electron transporting layer/cathode
4. Anode/hole transporting layer/first emitting layer/carrier blocking layer/second emitting layer/electron transporting layer/cathode
5. Anode/hole injecting layer/hole transporting layer/first emitting layer/carrier blocking layer/second emitting layer/electron transporting layer/cathode
6. Anode/hole injecting layer/hole transporting layer/first emitting layer/carrier blocking layer/second emitting layer/electron transporting layer/electron injecting layer/cathode

Of these, the configurations including a hole transporting layer are preferable.
Another organic layer or inorganic layer may be inserted in addition to the above layers. The inserted layer is not limited insofar as the layer can transport electrons and holes. When the inserted layer is provided in the light-outcoupling direction, the layer is preferably transparent.

Second embodiment

The organic EL device according to a second embodiment includes an anode, a first emitting layer, a carrier blocking layer, a second emitting layer, a third emitting layer and a cathode being stacked in that order. The first emitting layer, the second emitting layer and the third emitting layer each contain a host material and a dopant.
The host material of the first emitting layer is a hole transporting material and the host materials of the second emitting layer and the third emitting layer are each an electron transporting material. Further, the energy gap of the host material of the first emitting layer is smaller than the energy gap of the host material of the second emitting layer.
The carrier blocking layer has host transporting properties, and it is preferred that the affinity level of the carrier blocking layer be smaller than the affinity level of the host material of the second emitting layer in an amount of 0.2 eV or more.
The ionization potential of the carrier blocking layer (Ie1) and the ionization potential of the host material of the first emitting layer (Ih1) satisfy the following relationship:

$$Ie1<Ih1+0.1 \text{ (eV)} \qquad (1)$$

FIG. 3 is a view showing a configuration of an organic EL device according to the second embodiment of the invention.
An organic EL device 20 shown in FIG. 3 has a structure in which the anode 1, the hole transporting layer 2, the first emitting layer 3, the carrier blocking layer 4, the second emitting layer 5, a third emitting layer 8, the electron transporting layer 6, and the cathode 7 are stacked. That is, the organic EL device 20 has the same configuration as in the first embodiment except that the third emitting layer 8 is additionally formed. The third emitting layer 8 also contains a host material and a dopant. The host material of the third emitting layer 8 is an electron transporting material as that of the second emitting layer 5.
The organic EL device 20 can emit white light with excellent color rendition by using, for example, a red dopant as the dopant for the first emitting layer 3, a blue dopant as the dopant for the second emitting layer 5, and a green dopant as the dopant for the third emitting layer 8, so that the first emitting layer 3 emits red light, the second emitting

layer 5 emits blue light, and the third emitting layer 8 emits green light.
Normally, the blue dopant has an energy gap of about 2.8 eV, the green dopant has an energy gap of about 2.5 eV, and the red dopant has an energy gap of about 2.0 eV.

In this embodiment, the first emitting layer 3, the carrier blocking layer 4, and the second emitting layer 5 need not necessarily have the relationship described in the first embodiment. This is because the number of electrons injected into the first emitting layer 3, the carrier blocking layer 4, and the second emitting layer 5 is limited by forming the third emitting layer 8. In particular, since the third emitting layer is doped with a green dopant, electrons are trapped by this green dopant, whereby injection of electrons to the second emitting layer is restricted.
In order to further improve the performance of the device, it is preferable that the ionization potentials, affinity levels, and energy gaps of the host material of the first emitting layer 3, the carrier blocking layer 4, and the host material of the second emitting layer 5 have the same relationship as in the first embodiment.

The device configuration according to this embodiment is not limited to the configuration shown in FIG. 3, similarly to the first embodiment. For example, configurations in which the third emitting layer is additionally formed in the device configurations 1 to 6 illustrated in the first embodiment may be employed, or a plurality of carrier blocking layers may be stacked.

In the above embodiment, it is preferred that the host material of the first emitting layer be a compound shown by the following expression (1) and the dopant of the first emitting layer be a compound having a fluoranthene skeleton and a perylene skeleton.

$$X-(Y)n \qquad (1)$$

wherein X is a condensed aromatic ring group with 3 or more carbocycles,

Y is a group selected from a substituted or unsubstituted aryl group, a substituted or unsubstituted diarylamino group, a substituted or unsubstituted arylalkyl group and a substituted or unsubstituted alkyl group, and
n is an integer of 1 to 6, provided that Ys may be the same or different when n is 2 or more.

It is further preferred that the number of condensed rings in the host material of the first emitting layer be 4 or more. It is preferred that the number of condensed rings in the second emitting layer be 3 or less.

The embodiments of the invention have been described above. In the device according to the invention, the anode, the hole transporting first emitting layer, the carrier blocking layer, the electron transporting second emitting layer, and the cathode are stacked in that order. This configuration allows an organic EL device to exhibit color rendition and high luminous efficiency and shows a small change in chromaticity. The device according to the invention has a feature in which a change in chromaticity of emitted light is small even if the driving conditions (e.g. driving voltage) of the device are changed.

Third embodiment
The full-color emitting apparatus according to a third embodiment of the invention is provided with the white-emitting organic EL devices of the invention and color filters.

FIG. 4 is a view showing a configuration of the full-color emitting apparatus according to the third embodiment. In the full-color emitting apparatus 100 shown in FIG. 4, a first, second and third (white) organic EL devices 120, 130 and 140 are provided on a supporting substrate 110. In the light outcoupling direction (indicated by an arrow) of each of these devices 120, 130 and 140, a first (red), second (green) and third (blue) color filters 122, 132 and 142 are disposed in such a manner that they are faced to the devices 120, 130 and 140, respectively. The color filter 122, 132 and 142 are formed on a transparent substrate 150.
Light emitted by the organic EL device 120 is converted to red color light by the color filter 122 and outcoupled. Light emitted by the organic EL device 130 is converted to green light by the color filter 132 and outcoupled. Light emitted by the organic EL device 140 is converted to blue light by the color filter 142 and outcoupled. As a result, full-color emission is obtained.

Between the organic EL devices 120, 130 and 140 and the color filters 122, 132 and 142, a layer such as a sealing layer may be provided to prevent the organic EL device from being deteriorated by oxygen, moisture and other volatile components contained in the environment or the color filters. As examples of such a layer, layers of transparent inorganic compounds such as SiOxNy, AlOxNy and SiAlOxNy are used and these transparent inorganic compound layers are also used together with a transparent resin or sealing liquid layer.

As the color filters 122, 132 and 142, the following dyes only or the dyes in a solid state obtained by dissolving or dispersing a dye in a binder resin may be used.

Red (R) dye: perylene-based pigments, lake-based pigments, azo-based pigments or the like

Green (G) dyes: halogen-polysubstituted phthalocyanine-based pigments, halogen-polysubstituted copper phthalocyanine-based pigments, triphenylmethane-based basic dyes or the like

Blue (B) dyes: copper phthalocyanine-based pigments, indanthrone-based pigments, indophenol-based pigments, cyanine-based pigments or the like

The binder resin is preferably a transparent (50% or more of visible light transmittance). Examples include transparent resins (polymer) such as polymethyl methacrylate, polyacrylate, polycarbonate, polyvinyl alcohol, polyvinylpyrrolidone, hydroxyethyl cellulose, and carboxymethyl cellulose. In addition, as photosensitive resins to which the photolithographic method is applied, photo-curable resist materials having a reactive vinyl group such as acrylic acid-based, or methacrylic acid-based reactive vinyl groups may also be used. If the printing method is used, printing ink (medium) using a transparent resin such as polyvinyl chloride resin, melamine resin and phenol resin is used.

When the color filter is formed mainly of a dye, the filter is generally formed through a mask having a pattern of a desired color filter by vacuum deposition or sputtering. When the color filter is formed of a dye and a binder resin, the filter is generally formed as follows. The dye, resin and resist are mixed, dispersed or dissolved, and the mixture is then formed into a film by spin coating, roll coating, casting or by other methods, followed by patterning to a desired color filter pattern by photolithography, printing or the like.

The thickness and transmittance of each of the color filters 122, 132 and 142 are preferably as follows.

R: Thickness of 0.5 to 5.0 $\mu$m (transmittance of 50% or more/610 nm),

G: Thickness of 0.5 to 5.0 $\mu$m (transmittance of 50% or more/545 nm), and

B: Thickness of 0.2 to 5.0 $\mu$m (transmittance of 50% or more/460 nm)

In this embodiment, if a full-color emitting apparatus which emits three primary colors of red, green and blue is provided, a black matrix can be used to improve contrast ratio.

The carrier blocking layer, the hole transporting first emitting layer, and the electron transporting second emitting layer (third emitting layer), which are the characteristic portions of the organic EL device of the invention, are mainly described below. The configurations and the production methods of another organic layer, inorganic compound layer, anode, cathode, and the like may be those generally used in the art.

1. Carrier blocking layer

The hole mobility of a carrier blocking layer is preferably at least $10^{-5}$ $cm^2/V \cdot$second or more when an electric field of $10^4$ to $10^7$ V/cm is applied since the carrier blocking layer is less apt to be a barrier against holes.

Although not specially limited, the thickness of the carrier blocking layer is preferably 0.1 to 50 nm, more preferably 0.1 to 20 nm.

For the carrier blocking layer, various organic compounds and inorganic compounds can be used. The organic compounds include tertiary amine compounds, carbazole derivatives, compounds containing a nitrogen-containing heterocycle and metal complexes. The inorganic compounds include oxides, nitrides, composite oxides, sulfides and fluorides of metals such as Ba, Ca, Sr, Yb, Al, Ga, In, Li, Na, K, Cd, Mg, Si, Ta, Ge, Sb, Zn, Cs, Eu, Y, Ce, W, Zr, La, Sc, Rb, Lu, Ti, Cr, Ho, Cu, Er, Sm, W, Co, Se, Hf, Tm, Fe and Nb.

In particular, the organic compounds mentioned below, which are usually used for a hole transporting layer in an organic EL device, are preferably used since the carrier blocking layer is less apt to be a barrier against holes.

Specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive high-molecular oligomers (in particular thiophene oligomers) disclosed in JP-A-1-211399.

The following can also be used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others). Aromatic tertiary amine

compounds are preferably used.

Further, compounds represented by the following formula [1] are also preferred.

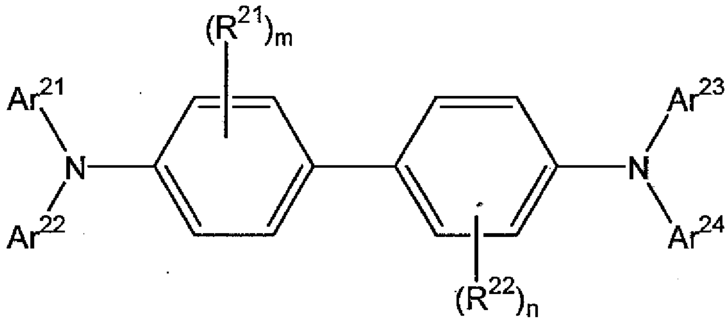

wherein $Ar^{21}$ to $Ar^{24}$ are independently a substituted or unsubstituted aryl group having 6 to 50 carbon atoms that form a ring, $R^{21}$ and $R^{22}$ are independently a hydrogen atom, a substituted and unsubstituted aryl group having 6 to 50 carbon atoms that form a ring or an alkyl group having 1 to 50 carbon atoms; and m and n are an integer of 0 to 4.

Examples of the aryl group having 6 to 50 carbon atoms that form a ring preferably include phenyl, naphthyl, biphenyl, terphenyl and phenanthryl group. The aryl group having 6 to 50 carbon atoms that form a ring may be substituted by a substituent. As preferable examples of the substituent, alkyl groups having 1 to 6 carbon atoms (methyl, ethyl, isopropyl, n-propyl, s-butyl, t-butyl, pentyl, hexyl, cyclopentyl, cyclohexyl and the like) and amino groups substituted by an aryl group having 6 to 50 carbon atoms that form a ring can be given.

As examples of the alkyl group having 1 to 50 carbon atoms, methyl, ethyl, isopropyl, n-propyl, s-butyl, t-butyl, pentyl, hexyl, cyclopentyl, cyclohexyl and the like are preferable.

The following can also be given as examples: 4,4'-bis(N-(1-naphthyl)-N-phenylamino)biphenyl (NPD), which has in the molecule thereof two condensed aromatic rings, disclosed in USP No. 5,061,569, and 4,4',4"-tris(N-(3-methylphenyl)-N-phenylamino)triphenylamine (MTDATA), wherein three triphenylamine units are linked in a star-burst form, disclosed in JP-A-4-308688.

An emitting material may be added to the carrier blocking layer, thereby obtaining emission containing various light components. For example, when the emitting layer has a double layer structure of the first emitting layer 3 and the second emitting layer 5 as in the first embodiment, a red dopant is used as the dopant for the first emitting layer 3, a blue dopant is used as the dopant for the second emitting layer, and a green dopant is used as the emitting material for the carrier blocking layer. That is, the blue emitting material of which the emission is the weakest is located in the region where the emission is the strongest, and the green emitting material of which the luminosity is high is located in the region where the emission is the next strongest. The reason therefore is as follows. If green emission is shifted, such a color shift is easily recognized by human eyes. As a result, it is difficult to obtain well-balanced white color. Red emission is obtained not only by injection of carriers but also by energy transfer from the blue emitting material and the green emitting material. Therefore, it suffices that the red emitting layer be located in the position of the first emitting layer. Due to such a configuration, 3-wavelength well-balanced white color which hardly encounters the color shift problem can be obtained efficiently. As the emitting materials, it is possible to use a dopant or other materials used in each of the emitting layers, which are described later.

If the carrier blocking layer contains an emitting material, the affinity level and the ionization potential of the carrier blocking layer are the affinity level and the ionization potential of the host material of the carrier blocking layer.

2. First emitting layer

For color of emitted light, the first emitting layer is preferably yellow-to-orange or red emitting layer in view of the energy gap relationship. The yellow-to-orange or red emitting layer is a layer which emits light having a maximum wavelength of 550 to 650 nm. The emitting layer contains a host material and a yellow-to-orange or red dopant.

As the host material, a compound represented by the following formula is used.

$$X-(Y)_n$$

wherein X is a condensed aromatic ring group having three or more carbocycles;

Y is a group selected from substituted or unsubstituted aryl, substituted or unsubstituted diarylamino, substituted or unsubstituted arylalkyl and substituted or unsubstituted alkyl groups, and
n is an integer of 1 to 6, provided that Ys may be the same or different when n is 2 or more.

X is preferably a group containing at least one skeleton selected from naphthacene, pyrene, anthracene, perylene, chrysene, benzoanthracene, pentacene, dibenzoanthracene, benzopyrene, benzofluorene, fluoranthene, benzofluoranthene, naphthylfluoranthene, dibenzofluorene, dibenzopyrene, dibenzofluoranthene and acenaphthylfluoranthene; and more preferably a group containing a naphthacene skeleton or anthracene skeleton.

Y is preferably an aryl group or a diarylamino group having 12 to 60 carbon atoms, more preferably an aryl group having 12 to 20 carbon atoms or a diarylamino group having 12 to 40 carbon atoms.
n is preferably 2.

The compound represented by the formula (1) is preferably a naphthacene derivative represented by the following formula (4).

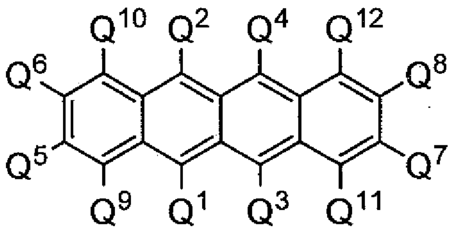

(4)

wherein $Q^1$ to $Q^{12}$, which may be the same or different, are independently a hydrogen atom, a substituted or unsubstituted alkyl group having 1 to 20 carbon atoms, a substituted or unsubstituted aryl group having 6 to 20 carbon atoms that form a ring, an amino group, a substituted or unsubstituted alkoxy group having 1 to 20 carbon atoms, a substituted or unsubstituted alkylthio group having 1 to 20 carbon atoms, a substituted or unsubstituted aryloxy group having 6 to 20 carbon atoms that form a ring, a substituted or unsubstituted arylthio group having 6 to 20 carbon atoms that form a ring, a substituted or unsubstituted alkenyl group having 2 to 20 carbon atoms, a substituted or unsubstituted aralkyl group having 7 to 20 carbon atoms that form a ring or a substituted or unsubstituted heterocyclic group having 5 to 20 atoms that form a ring.

The compound represented by formula (4) is more preferably a compound in which at least one of $Q^1$, $Q^2$ , $Q^3$ and $Q^4$ is an aryl group.

More preferably, the naphthacene derivative represented by formula (4) is a compound represented by formula (5).

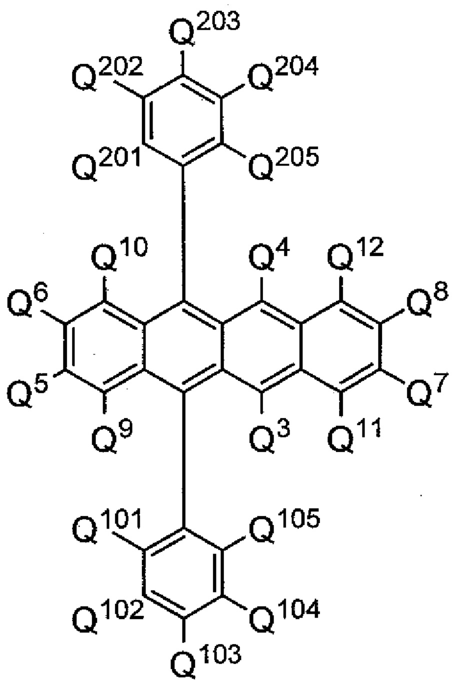

(5)

wherein $Q^3$ to $Q^{12}$, $Q^{101}$ to $Q^{105}$, and $Q^{201}$ to $Q^{205}$ are independently the same group as that mentioned for $Q^3$ to $Q^{12}$ in formula (1) above, and adjacent two or more thereof may be bonded to each other to form a ring.

More preferably, in the naphthacene derivative represented by formula (5), at least one of $Q^{101}$, $Q^{105}$, $Q^{201}$ and $Q^{205}$ is an alkyl group, an aryl group, an amino group, an alkoxy group, an aryloxy group, an alkylthio group, an arylthio group, an alkenyl group, an aralkyl group or a heterocyclic group, which may be the same or different.

There can be used as a yellow-to-orange or red dopant a fluorescent compound containing at least one of a fluoranthene skeleton and a perylene skeleton. Examples thereof include compounds represented by the following formulas [2] to [18].

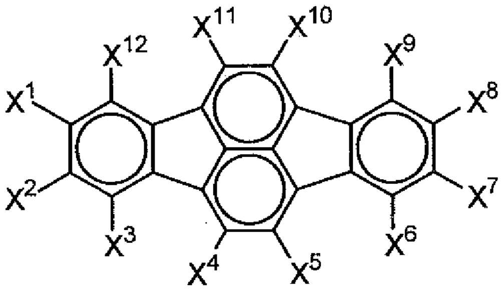

[2]

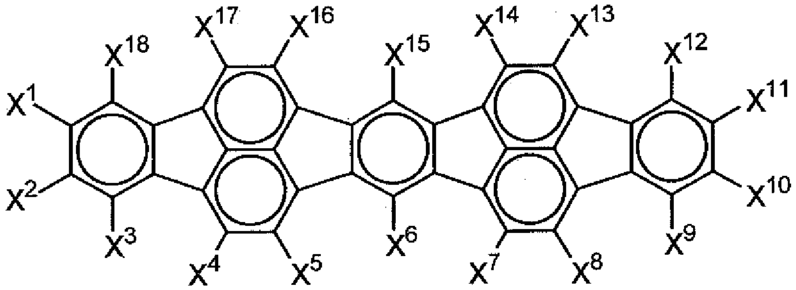

[3]

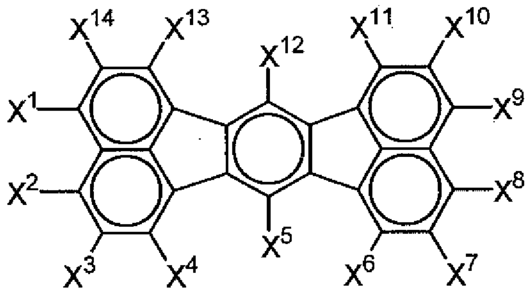

[4]

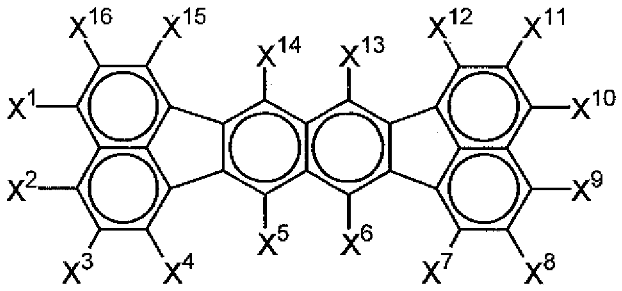

〔5〕

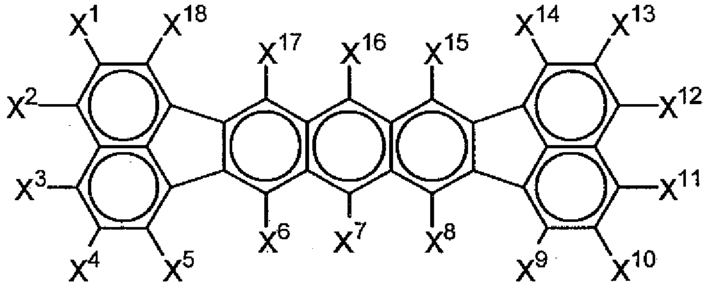

〔6〕

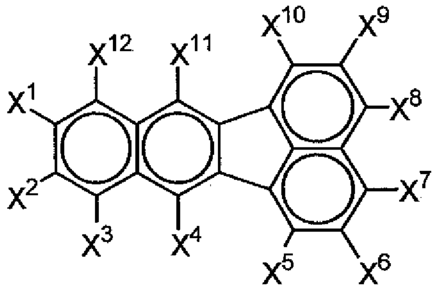

〔7〕

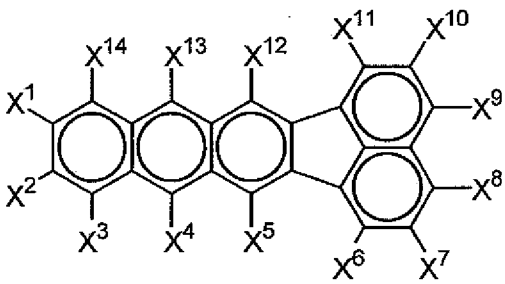

〔8〕

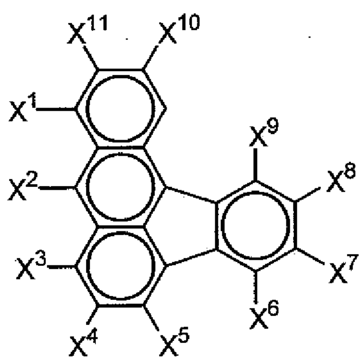

〔9〕

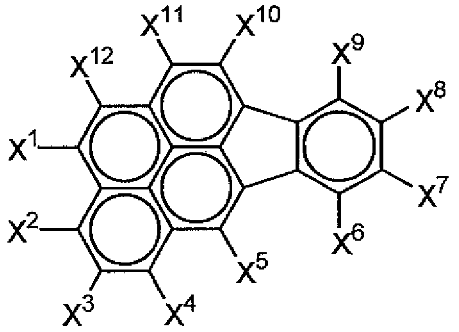

〔1 0〕

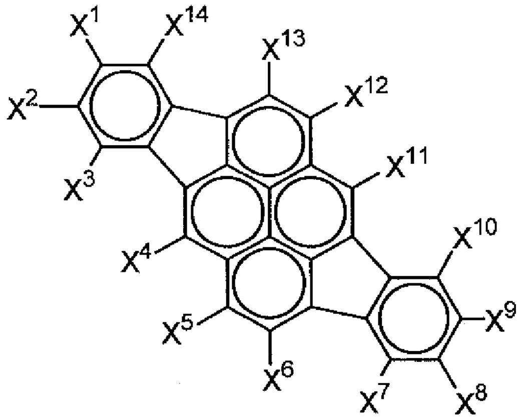

〔1 1〕

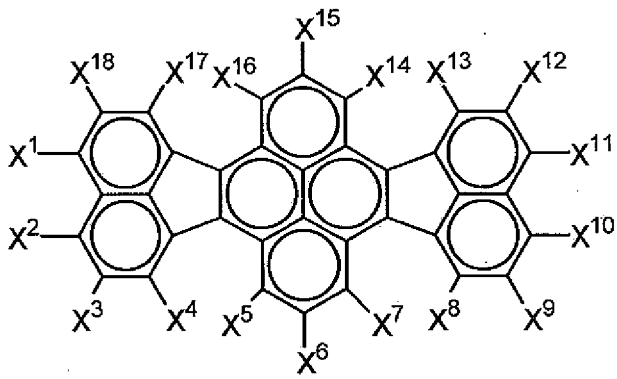

〔1 2〕

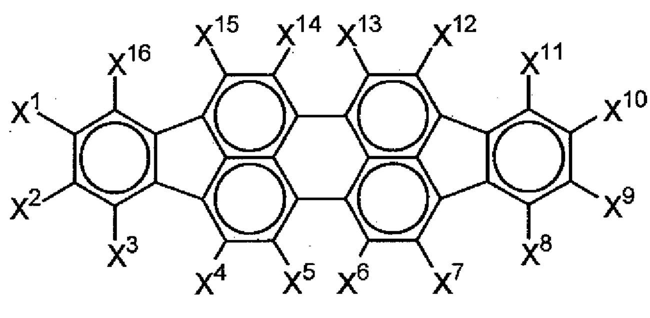

〔1 3〕

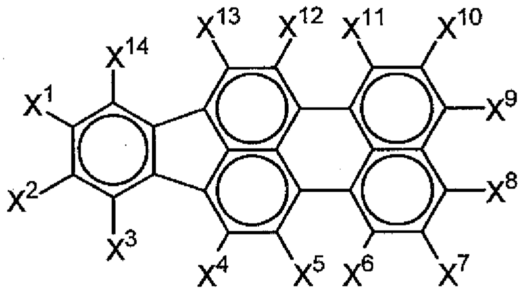

[14]

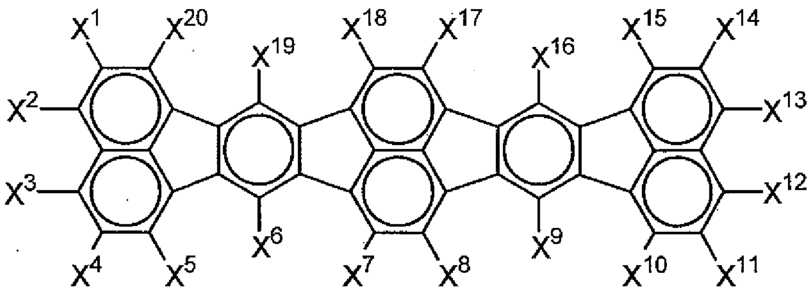

[15]

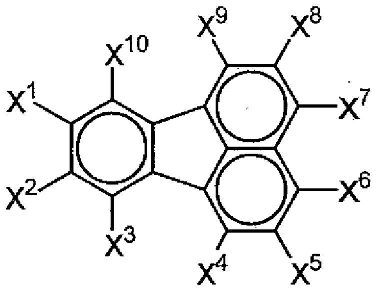

[16]

In formulas [2] to [16], $X^1$ to $X^{20}$ are independently a hydrogen atom, a linear, branched or cyclic alkyl group having 1 to 20 carbon atoms, a linear, branched or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms or a substituted or unsubstituted alkenyl group having 8 to 30 carbon atoms; adjacent substituents and $X^1$ to $X^{20}$ may be bonded to each other to form a ring structure; and when adjacent substituents are an aryl group, the substituents may be the same.

The compounds of the formulae [2] to [16] preferably contain an amino group or an alkenyl group.

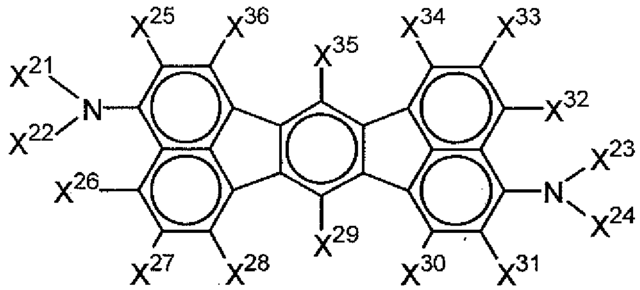

[17]

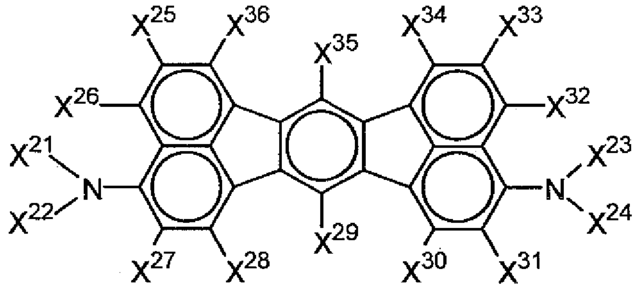

[18]

In formulas [17] and [18], $X^{21}$ to $X^{24}$ are independently an alkyl group having 1 to 20 carbon atoms, a substituted or unsubstituted aryl group having 6 to 30 carbon atoms; $X^{21}$ and $X^{22}$ and/or $X^{23}$ and $X^{24}$ may be bonded to each other with a carbon to carbon bond, -O- or -S- therebetween;

$X^{25}$ to $X^{36}$ are independently a hydrogen atom, a linear, branched or cyclic alkyl group having 1 to 20 carbon atoms, a linear, branched or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms or a substituted or unsubstituted alkenyl group with 8 to 30 carbon atoms; and adjacent substituents and $X^{25}$ to $X^{36}$ may be bonded to each other to form a ring structure.

At least one of the substituents $X^{25}$ to $X^{36}$ in each of the formulas preferably contains an amine or alkenyl group.

The compound is preferably an indenoperylene derivative represented by the formula [13] or [14].

A fluorescent compound containing a fluoranthene skeleton preferably contains an electron-donating group for high performance and long lifetime. A preferable electron-donating group is a substituted or unsubstituted arylamino group. A fluorescent compound containing a fluoranthene skeleton preferably has 5 or more condensed rings, more preferably 6 or more condensed rings, for the following reason. The fluorescent compound has a fluorescent peak wavelength of 540 to 700 nm. The emission from a blue emitting material and emission from the fluorescent compound overlap to give a white color.

The above-mentioned fluorescent compound preferably contains a plurality of fluoranthene skeletons since the emitted light color falls in the yellow-to-orange or red zone.

A particularly preferred indenoperylene derivative is a dibenzotetraphenylperiflanthene derivative.

The thickness of first emitting layer is preferably 1 to 50 nm, and more preferably 5 to 50 nm. When it is less than 1 nm, the luminous efficiency may decrease. When it exceeds 50 nm, the driving voltage may increase.

3. Second emitting layer

In regard to the emission color, it is preferable that the second emitting layer be a blue emitting layer from the view point of the energy gap relationship. The maximum peak wavelength of the blue light is preferably 450 to 500 nm. As examples of the dopant which may be used for the second emitting layer, an arylamine compound and/or styryl amine compound, anthracene, naphthalene, phenanthrene, pyrene, tetracene, coronene, chrysene, fluoresceine, perylene, phthaloperylene, naphthaloperylene, perynone, phthaloperynone, naphthaloperynone, diphenylbutadiene, tetraphenylbutadiene, coumarin, oxadizole, aldazine, bisbenzoxazoline, bisstyryl, pyrazine, cyclopentadiene, quinoline metal complex, aminoquinoline metal complex, benzoquinoline metal complex, imine, diphenylethylene, vinylanthracene, diaminocarbazole, pyrane, thiopyran, polymethine, merocyanine, imidazole chelated oxynoid compound, quinacridon, rubrene, fluorescent dye, and the like can be given. Note that the material for the second emitting layer is not limited thereto.

In the organic EL device of the invention, the second emitting layer preferably contains an arylamine compound and/or a styrylamine compound.
As examples of the arylamine compound, a compound of the following formula (A) can be given. As examples of the styrylamine compound, a compound of the following formula (B) can be given.

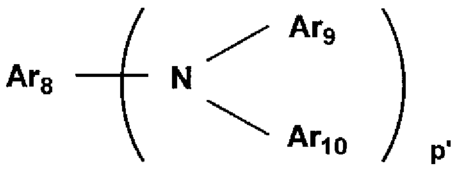

(A)

wherein $Ar_8$ is a group selected from phenyl, biphenyl, terphenyl, stilbene, and distyrylaryl, and $Ar_9$ and $Ar_{10}$ are independently a hydrogen atom or an aromatic group having 6 to 20 carbon atoms, provided that $Ar_9$ and $Ar_{10}$ may be substituted. p' is an integer of 1 to 4. More preferably, $Ar_9$ and/or $Ar_{10}$ is substituted with a styryl group.
As the aromatic group having 6 to 20 carbon atoms, a phenyl group, naphthyl group, anthracenyl group, phenanthryl group, terphenyl group, and the like are preferable.
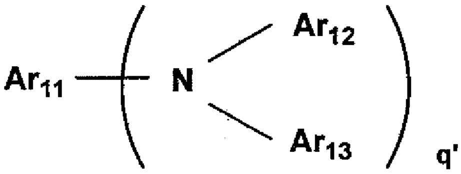

(B)

wherein $Ar_{11}$ to $Ar_{13}$ are aryl groups having 5 to 40 carbon atoms that form a ring which may be substituted. q' is an integer of 1 to 4.
As the aryl groups having 5 to 40 atoms that form a ring, phenyl, naphthyl, anthracenyl, phenanthryl, pyrenyl, coronyl, biphenyl, terphenyl, pyrrolyl, furanyl, thiophenyl, benzothiophenyl, oxadiazolyl, diphenylanthracenyl, indolyl, carbazolyl, pyridyl, benzoquinolyl, fluoranthenyl, acenaphthofluoranthenyl, stilbene, and the like are preferable. The aromatic group having 5 to 40 carbon atoms that form a ring may be substituted with a substituent. Given as preferred substituents are alkyl groups having 1 to 6 carbon atoms (e.g. ethyl group, methyl group, i-propyl group, n-propyl group, s-butyl group, t-butyl group, pentyl group, hexyl group, cyclopentyl group, and cyclohexyl group), alkoxy groups having 1 to 6 carbon atoms (e.g. ethoxy group, methoxy group, i-propoxy group, n-propoxy group, s-butoxy group, t-butoxy group, pentoxy group, hexyloxy group, cyclopentoxy group, and cyclohexyloxy group), aryl groups having 5 to 40 atoms that form a ring, amino groups substituted with an aryl group having 5 to 40 atoms that form a ring, ester groups containing an aryl group having 5 to 40 atoms that form a ring, ester groups containing an alkyl group having 1 to 6 carbon atoms, cyano group, nitro group, and halogen atoms (e.g. chlorine, bromine, and iodine).
As the host material for use in the second emitting layer, compounds having a structure represented by the following formula (19), which has an anthracene main skeleton, are preferable.

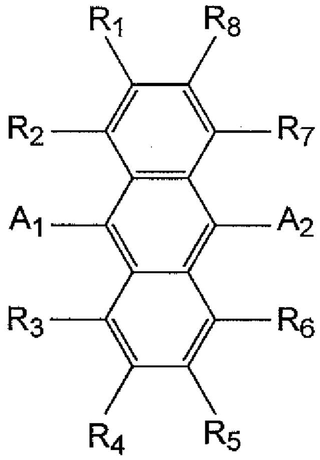

(19)

wherein $A_1$ and $A_2$ are independently a group derived from a substituted or unsubstituted aromatic ring having 6 to 20 carbon atoms that form a ring. $R_1$ to $R_8$ are independently a hydrogen atom, a substituted or unsubstituted aryl group having 6 to 50 carbon atoms that form a ring, a substituted or unsubstituted heteroaryl group having 5 to 50 atoms that form a ring, a substituted or unsubstituted alkyl group having 1 to 50 carbon atoms, a substituted or unsubstituted cycloalkyl group having 3 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 atoms that form a ring, a substituted or unsubstituted arythio group having 5 to 50 atoms that form a ring, a substituted or unsubstituted alkoxycarbonyl group having 1 to 50 carbon atoms, a substituted or unsubstituted silyl group, a carboxyl group, a halogen atom, a cyano group, a nitro group or a hydroxy group.

The aromatic ring represented by $A_1$ and $A_2$ may be substituted with one or more substituents. The substituent is selected from a substituted or unsubstituted aryl group having 6 to 50 carbon atoms that form a ring, a substituted or unsubstituted alkyl group having 1 to 50 carbon atoms, a substituted or unsubstituted cycloalkyl group having 3 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 atoms that form a ring, a substituted or unsubstituted arythio group having 5 to 50 atoms that form a ring, a substituted or unsubstituted alkoxycarbonyl group having 1 to 50 carbon atoms, a substituted or unsubstituted silyl group, a carboxyl group, a halogen atom, a cyano group, a nitro group and a hydroxy group.

When the aromatic ring represented by $A_1$ and $A_2$ is substituted with two or more substituents, these substituents may be either the same or different, and adjacent substituents may be bonded to each other to form a saturated or unsaturated ring structure.

In the above formula (19), it is preferred that $A_1$ and $A_2$ be different from each other.

The compounds represented by the following formulas (i) to (ix) are preferred.

Asymmetrical anthracene represented by the following formula (i)

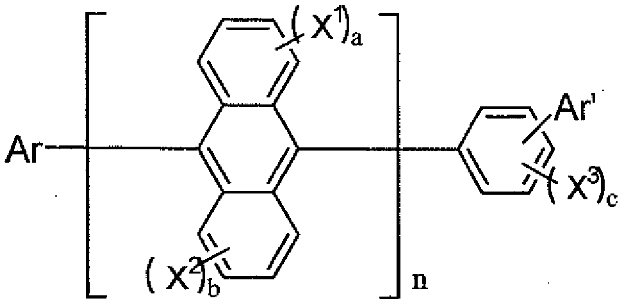

(i)

wherein Ar is a substituted or unsubstituted condensed aromatic group having 10 to 50 carbon atoms that form a ring,

Ar' is a substituted or unsubstituted aromatic group having 6 to 50 carbon atoms that form a ring,
$X^1$, $X^2$ and $X^3$ are independently a substituted or unsubstituted aromatic group having 6 to 50 carbon atoms that form a ring, a substituted or unsubstituted aromatic heterocyclic group having 5 to 50 atoms that form a ring, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 atoms that form a ring, a substituted or unsubstituted arythio group having 5 to 50 atoms that form a ring, a substituted or unsubstituted alkoxycarbonyl group having 1 to 50 carbon atoms, a carboxyl group, a halogen atom, a cyano group, a nitro group or a hydroxyl group.
a, b and c are each an integer of 0 to 4. When a, b and c are two or more, $X^1$s, $X^2$s and $X^3$s may be the same or different.
n is an integer of 1 to 3. When n is 2 or more, the anthracene in [ ] may be the same or different.

Asymmetrical monoanthracene derivatives represented by the following formula (ii)

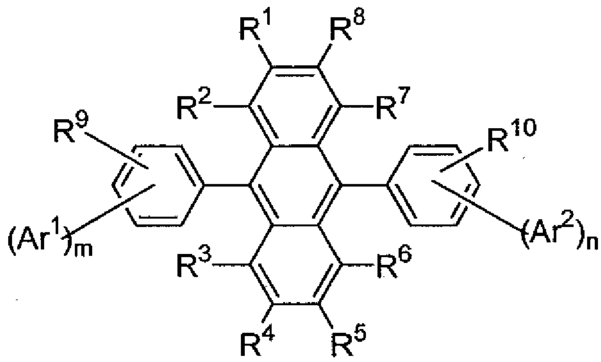

(ii)

wherein $Ar^1$ and $Ar^2$ are independently a substituted or unsubstituted aromatic ring group having 6 to 50 carbon atoms that form a ring, and m and n are independently an integer of 1 to 4, provided that in the case where m=n=1 and $Ar^1$ and $Ar^2$ are symmetrically bonded to the benzene rings, $Ar^1$ and $Ar^2$ are not the same, and in the case where m or n is an integer of 2 to 4, m is different from n,

$R^1$ to $R^{10}$ are independently a hydrogen atom, a substituted or unsubstituted aromatic ring group having 6 to 50 carbon atoms that form a ring, a substituted or unsubstituted aromatic hetrocyclic group having 5 to 50 atoms that form a ring, a substituted or unsubstituted alkyl group having 1 to 50 carbon atoms, a substituted or unsubstituted cycloalkyl group, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 atoms that form a ring, a substituted or unsubstituted arylthio group having 5 to 50 atoms that form a ring, a substituted or unsubstituted alkoxycarbonyl group having 1 to 50 carbon atoms, a substituted or unsubstituted silyl group, a carboxyl group, a halogen atom, a cyano group, a nitro group or a hydroxyl group.

Asymmetrical pyrene derivatives represented by the following formula (iii)

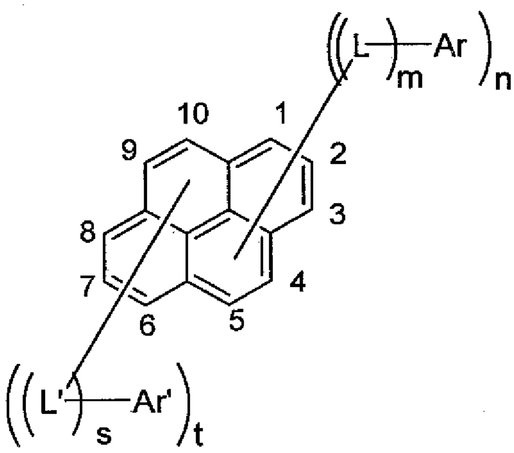

(iii)

wherein Ar and Ar' are independently a substituted or unsubstituted aromatic group having 6 to 50 carbon atoms that form a ring;

L and L' are independently a substituted or unsubstituted phenylene group, a substituted or unsubstituted naphthalenylene group, a substituted or unsubstituted fluolenylene group, or a substituted or unsubstituted dibenzosilolylene group;
m is an integer of 0 to 2, n is an integer of 1 to 4, s is an integer of 0 to 2, and t is an integer of 0 to 4;
L or Ar bonds at any one position of 1 to 5 of the pyrene, and L' or Ar' bonds at any one position of 6 to 10 of the pyrene;

provided that when n+t is an even number, Ar, Ar', L and L' satisfy the following (1) and (2):

(1) Ar≠Ar' and/or L≠L' where ≠ means these substituents are groups having different structures from each other.
(2) when Ar=Ar' and L= L',

(2-1) m≠s and/or n≠t, or
(2-2) when m=s and n=t,

(2-2-1) L and L', or the pyrene each bond to Ar and Ar' at different positions, or
(2-2-2) when L and L', or the pyrene each bond to Ar and Ar' at the same positions, the pyrene is neither substituted by L and L', or Ar and Ar' at 1 and 6 positions, nor 2 and 7 positions.

Asymmetrical anthracene represented by the following formula (iv)

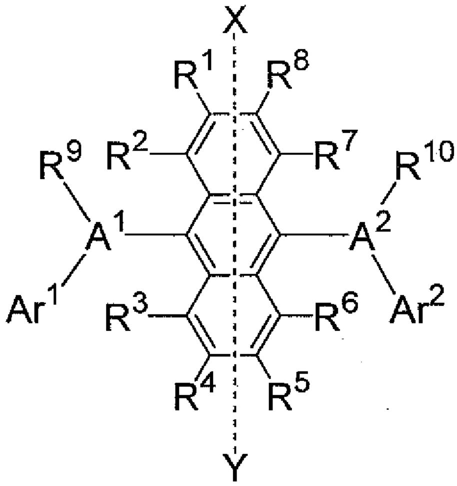

(iv)

wherein $A^1$ and $A^2$ are independently a substituted or unsubstituted condensed aromatic ring group having 10 to 20 carbon atoms that form a ring,

$Ar^1$ and $Ar^2$ are independently a hydrogen atom or a substituted or unsubstituted aromatic ring group having 6 to 50 carbon atoms that form a ring,

$R^1$ to $R^{10}$ are independently a hydrogen atom or a substituted or unsubstituted aromatic ring group having 6 to 50 carbon atoms that form a ring, a substituted or unsubstituted aromatic hetrocyclic group having 5 to 50 atoms that form a ring, a substituted or unsubstituted alkyl group having 1 to 50 carbon atoms, a substituted or unsubstituted cycloalkyl group, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 atoms that form a ring, a substituted or unsubstituted arylthio group having 5 to 50 atoms that form a ring, a substituted or unsubstituted alkoxycarbonyl group having 1 to 50 carbon atoms, a substituted or unsubstituted silyl group, a carboxyl group, a halogen atom, a cyano group, a nitro group or a hydroxyl group, and

each of $Ar^1$, $Ar^2$, $R^9$ and $R^{10}$ may be plural, and adjacent groups thereof may form a saturated or unsaturated ring structure,

provided that groups do not symmetrically bond to 9 and 10 positions of the central anthracene with respect to X-Y axis.

Anthracene derivative represented by the following formula (v)

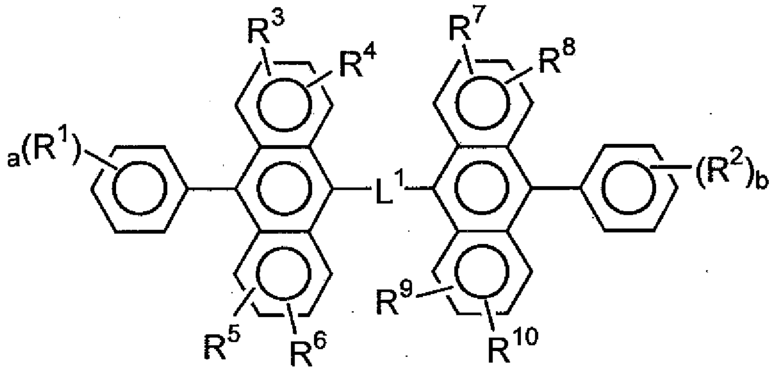

(v)

wherein $R^1$ to $R^{10}$ are independently a hydrogen atom, an alkyl group, a cycloalkyl group, an aryl group which may be substituted, an alkoxy group, an aryloxy group, an alkylamino group, an alkenyl group, an arylamino group or a heterocyclic group which may be substituted; a and b are each an integer of 1 to 5; when they are 2 or more, $R^1$s or $R^2$s may be the same or different, or $R^1$s or $R^2$s may be bonded to each other to form a ring; $R^3$ and $R^4$, $R^5$ and $R^6$, $R^7$ and $R^8$, or $R^9$ and $R^{10}$ may be bonded to each other to form a ring; and $L^1$ is a single bond, -O-, -S-, -N(R)- (R is an alkyl group or a substituted or unsubstituted aryl group), an alkylene group or an arylene group.

Anthracene derivative represented by the following formula (vi)

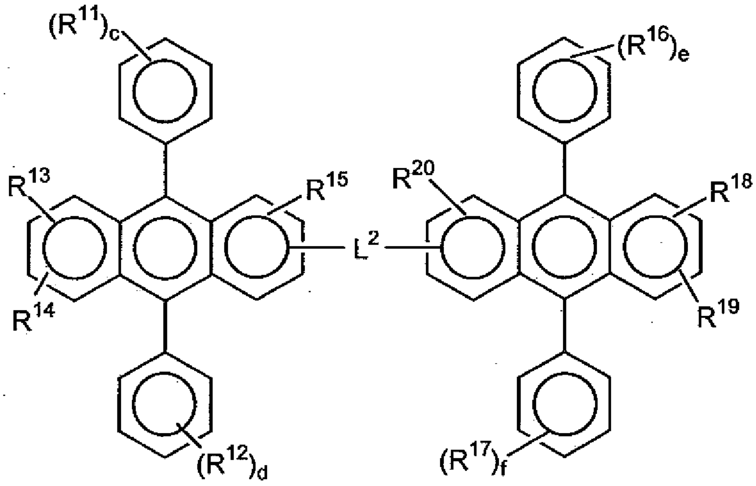

(vi)

wherein $R^{11}$ to $R^{20}$ are independently a hydrogen atom, an alkyl group, a cycloalkyl group, an aryl group, an alkoxy group, an aryloxy group, an alkylamino group, an arylamino group or a heterocyclic group which may be substituted; c, d, e and f are each an integer of 1 to 5; when they are 2 or more, $R^{11}$s, $R^{12}$s, $R^{16}$s or $R^{17}$s may be the same or different, $R^{11}$s, $R^{12}$s, $R^{16}$s or $R^{17}$s may be bonded to each other to form a ring, or $R^{13}$ and $R^{14}$, or $R^{18}$ and $R^{19}$ may be bonded to each other to form a ring; and $L^2$ is a single bond, -O-, -S-, -N(R)- (R is an alkyl group or a substituted or unsubstituted aryl group), an alkylene group or an arylene group.

Spirofluorene derivatives represented by the following formula (vii)

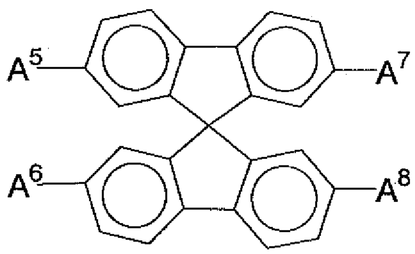

(vii)

wherein $A^5$ to $A^6$ are independently a substituted or unsubstituted biphenyl group or a substituted or unsubstituted naphthyl group.

Condensed ring-containing compounds represented by the following formula (viii)

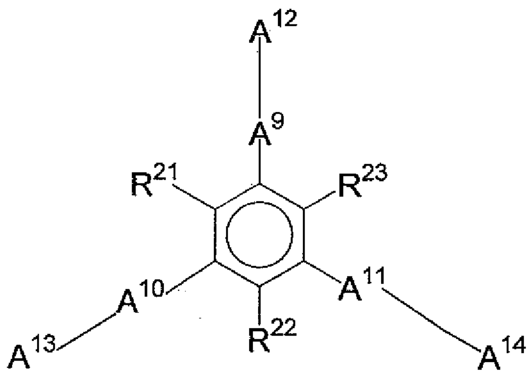

(viii)

wherein $A^9$ to $A^{11}$ are independently a single bond or a substituted or unsubstituted arylene group having 6 to 50 carbon atoms that form a ring, $A^{12}$ to $A^{14}$ are independently a hydrogen atom or a substituted or unsubstituted aryl group having 6 to 50 carbon atoms that form a ring, and $R^{21}$ to $R^{23}$ are independently a hydrogen atom, alkyl group having 1 to 6 carbon atoms, cycloalkyl group having 3 to 6 carbon atoms, alkoxy group having 1 to 6 carbon atoms, aryloxy group having 5 to 18 carbon atoms, aralkyloxy group having 7 to 18 carbon atoms, arylamino group having 5 to 16 carbon atoms, nitro group, cyano group, ester group having 1 to 6 carbon atoms, or a halogen atom, provided that at least one of $A^9$ to $A^{14}$ is a group having a condensed aromatic ring with three or more rings.

Fluorene compounds represented by the following formula (ix)

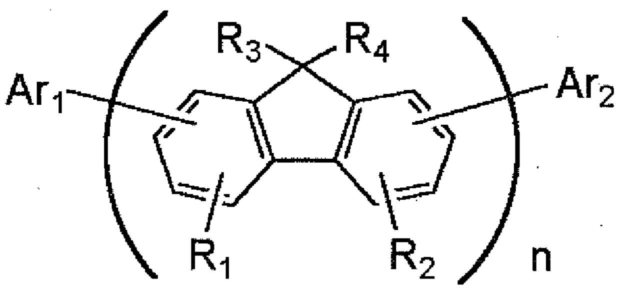

(ix)

wherein $R_1$ and $R_2$ are a hydrogen atom, a substituted or unsubstituted alkyl group, a substituted or unsubstituted aralkyl group, a substituted or unsubstituted aryl group, a substituted or unsubstituted heterocyclic group, substituted amino group, cyano group, or a halogen atom. $R_1$s or $R_2$s bonded to different fluorene groups may be the same or different, and $R_1$ and $R_2$ bonded to a single fluorene group may be the same or different. $R_3$ and $R_4$ are a hydrogen atom, a substituted or unsubstituted alkyl group, a substituted or unsubstituted aralkyl group, a substituted or unsubstituted aryl group, or a substituted or unsubstituted heterocyclic group, provided that $R_3$s or $R_4$s bonded to different fluorene groups may be the same or different, and $R_3$ and $R_4$ bonded to a single fluorene group may be the same or different. $Ar_1$ and $Ar_2$ are a substituted or unsubstituted condensed polycyclic aromatic group with a total number of benzene rings of three or more or a condensed polycyclic heterocyclic group which is bonded to the fluorene group through substituted or unsubstituted carbon and has a total number of benzene rings and heterocyclic rings of three or more, provided that $Ar_1$ and $Ar_2$ may be the same or different. n is an integer of 1 to 10.

Among the above compounds, the host material is preferably the anthracene derivative, more preferably the monoanthracene derivative, and particularly the asymmetrical anthracene.

The blue dopant is preferably at least one selected from styrylamines, amine-substituted styryl compounds, and condensed-aromatic-ring containing compounds. The blue dopant may be formed of plural different compounds. Examples of the styrylamines and amine-substituted styryl compounds are compounds represented by formulas [20] and [21], and examples of the condensed-aromatic-ring containing compounds are compounds represented by formula [22].

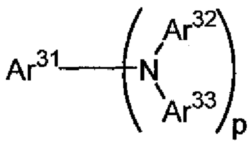

[20]

wherein $Ar^{31}$, $Ar^{32}$ and $Ar^{33}$ are independently a substituted or unsubstituted aromatic group having 6 to 40 carbon atoms and at least one thereof preferably contains a styryl group; and p is an integer of 1 to 3.

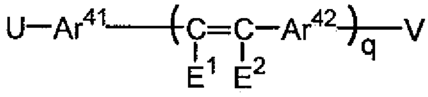

[21]

wherein $Ar^{41}$ and $Ar^{42}$ are independently an arylene group having 6 to 30 carbon atoms, $E^1$ and $E^2$ are independently an aryl or alkyl group having 6 to 30 carbon atoms, a hydrogen atom or a cyano group; q is an integer of 1 to 3; and U and/or V is a substituent containing an amino group and the amino group is preferably an arylamino group.

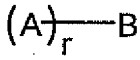

[22]

wherein A is an alkyl or alkoxy group having 1 to 16 carbon atoms, a substituted or unsubstituted aryl group having 6 to 30 carbon atoms, a substituted or unsubstituted alkylamino group having 6 to 30 carbon atoms or a substituted or unsubstituted arylamino group having 6 to 30 carbon atoms; B is a condensed aromatic group having 10 to 40 carbon atoms; and r is an integer of 1 to 4.

The green dopant is preferably the arylamine compound and/or the styrylamine compound given as the blue dopant. The maximum peak wavelength of the green light is preferably 500 to 550 nm.
The green dopant is preferably an aromatic amine compound of the following formula (1).

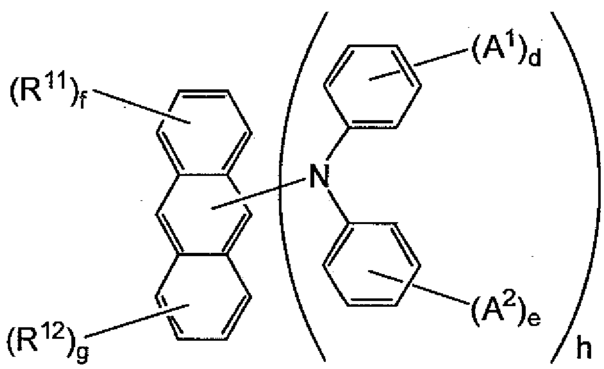

(1)

In the formula (1), $A^1$ to $A^2$ are independently a hydrogen atom, a substituted or unsubstituted alkyl group having 1 to 10 carbon atoms (preferably 1 to 6 carbon atoms), a substituted or unsubstituted aryl group having 5 to 50 carbon atoms that form a ring (preferably 5 to 10 carbon atoms that form a ring), a substituted or unsubstituted cycloalkyl group having 3 to 20 carbon atoms that form a ring (preferably 5 to 10 carbon atoms that form a ring), a substituted or unsubstituted alkoxy group having 1 to 10 carbon atoms (preferably 1 to 6 carbon atoms), a substituted or unsubstituted

aryloxy group having 5 to 50 carbon atoms that form a ring (preferably 5 to 10 carbon atoms that form a ring), a substituted or unsubstituted arylamino group having 5 to 50 carbon atoms that form a ring (preferably 5 to 20 carbon atoms that form a ring), a substituted or unsubstituted alkylamino group having 1 to 10 carbon atoms (preferably 1 to 6 carbon atoms), or a halogen atom.

The substituted or unsubstituted alkyl group of $A^1$ to $A^2$ includes methyl, ethyl, propyl, isopropyl, butyl, sec-butyl, tert-butyl, pentyl, hexyl, heptyl, octyl, stearyl, 2-phenylisopropyl, trichloromethyl, trifluoromethyl, benzyl, α-phenoxybenzyl, α,α-dimethylbenzyl, α,α-methylphenylbenzyl, α,α-ditrifluoromethylbenzyl, triphenylmethyl, and α-benzyloxybenzyl groups.

The substituted or unsubstituted aryl group of $A^1$ to $A^2$ includes phenyl, 2-methylphenyl, 3-methylphenyl, 4-methylphenyl, 4-ethylphenyl, biphenyl, 4-methylbiphenyl, 4-ethylbiphenyl, 4-cyclohexylbiphenyl, terphenyl, 3,5-dichlorophenyl, naphtyl, 5-methylnaphtyl, anthryl, and pyrenyl groups.

The substituted or unsubstituted cycloalkyl group of $A^1$ to $A^2$ includes cyclopropyl, cyclobutyl, cyclopentyl, cyclohexyl, norbornyl, and adamantyl groups.

The substituted or unsubstituted alkoxy group of $A^1$ to $A^2$ includes methoxy, ethoxy, propoxy, isopropoxy, butoxy, isobutoxy, sec-butoxy, tert-butoxy, various pentyloxy, and various hexyloxy groups.

The substituted or unsubstituted aryloxy group of $A^1$ to $A^2$ includes phenoxy, tolyloxy, and naphthyloxy groups.
The substituted or unsubstituted arylamino group of $A^1$ to $A^2$ includes diphenylamino, ditolylamino, dinaphthylamino, and naphthylphenylamino groups.
The substituted or unsubstituted alkylamino group of $A^1$ to $A^2$ includes dimethylamino, diethylamino, and dihexylamino groups.
The halogen atom of $A^1$ to $A^2$ includes fluoride, chlorine, and bromine atoms.
In formula (1), $A^1$ and $A^2$ cannot be hydrogen atoms at the same time.

In formula (1), d and e are each an integer of 1 to 5, preferably 1 to 3. When d and e are each 2 or more, $A^1$s and $A^2$s may be the same or different. They may be bonded to each other to form a saturated or unsaturated ring. h is an integer of 1 to 9, preferably 1 to 3.

$R^{11}$ is a substituted or unsubstituted secondary or tertiary alkyl group having 3 to 10 carbon atoms or a substituted or unsubstituted secondary or tertiary cycloalkyl group having 3 to 10 carbon atoms.
The substituted or unsubstituted secondary or tertiary alkyl group having 3 to 10 carbon atoms of $R^{11}$ includes isopropyl, tert-butyl, sec-butyl, tert-pentyl, 1-methylbutyl, 1-methylpentyl, 1,1'-dimethylpentyl, 1,1'-diethylpropyl, 1-benzyl-2-phenylethyl, 1-methoxyethyl, and 1-phenyl-1-methylethyl groups.
The substituted or unsubstituted secondary or tertiary cycloalkyl group having 3 to 10 carbon atoms of $R^{11}$ includes cyclopentyl, cyclohexyl, norbornyl, and adamantyl groups.
In formula (1), f is an integer of 1 to 9, preferably 1 to 3. When f is 2 or more, $R^{11}$s may be the same or different.

$R^{12}$ is a hydrogen atom, a substituted or unsubstituted alkyl group having 1 to 10 carbon atoms (preferably 1 to 6 carbon atoms), a substituted or unsubstituted aryl group having 5 to 50 carbon atoms that form a ring (preferably 5 to 10 carbon atoms that form a ring), a substituted or unsubstituted cycloalkyl group having 3 to 20 carbon atoms that form a ring (preferably 5 to 10 carbon atoms that form a ring), a substituted or unsubstituted alkoxy group having 1 to 10 carbon atoms (preferably 1 to 6 carbon atoms), a substituted or unsubstituted aryloxy group having 5 to 50 carbon atoms that form a ring (preferably 5 to 10 carbon atoms that form a ring), a substituted or unsubstituted arylamino group having 5 to 50 carbon atoms that form a ring (preferably 5 to 20 carbon atoms that form a ring), a substituted or unsubstituted alkylamino group having 1 to 10 carbon atoms (preferably 1 to 6 carbon atoms), or a halogen atom.
Examples of the substituted or unsubstituted alkyl, aryl, cycloalkyl, alkoxy, aryloxy, arylamino, and alkylamino groups and halogen atom of $R^{12}$ include the same groups and atoms as those of $A^1$ to $A^2$ mentioned above.
In formula (1), g is an integer of 0 to 8 and preferably 0 to 2.
When g is 2 or more, $R^{12}$s may be the same or different.
In formula (1), f+g+h is an integer of 2 to 10 and preferably 2 to 6.

More preferred are compounds represented by formulas (1-1) to (1-7) as the aromatic amine compound.

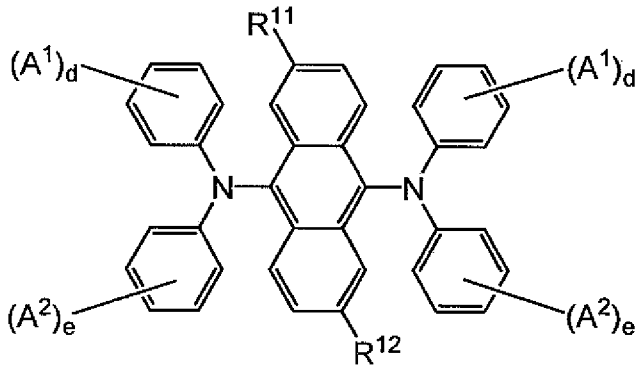

(1-1)

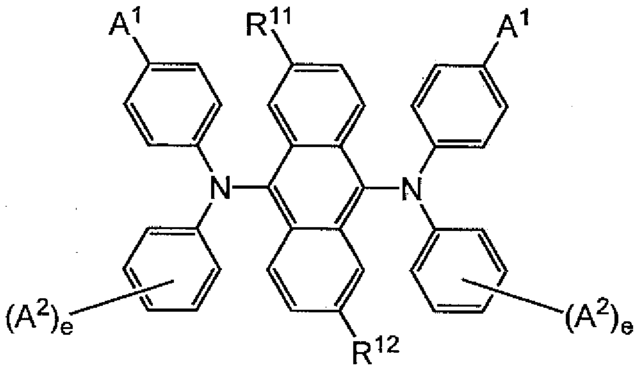

(1-2)

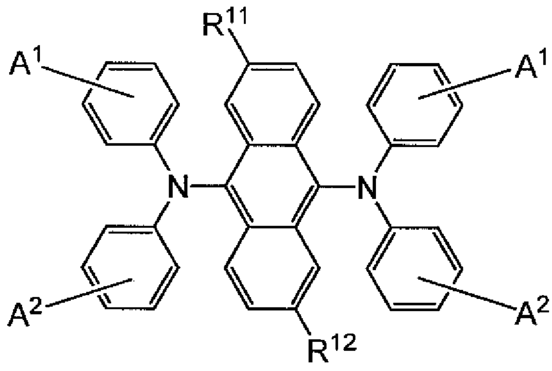

(1-3)

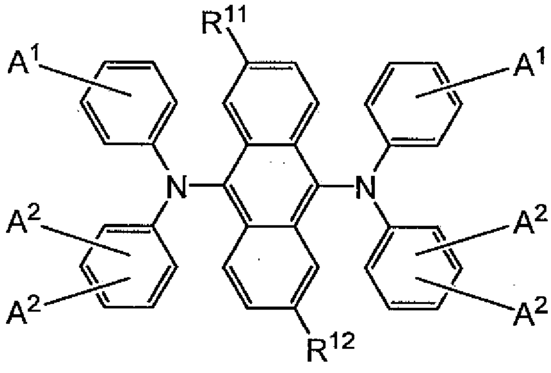

(1-4)

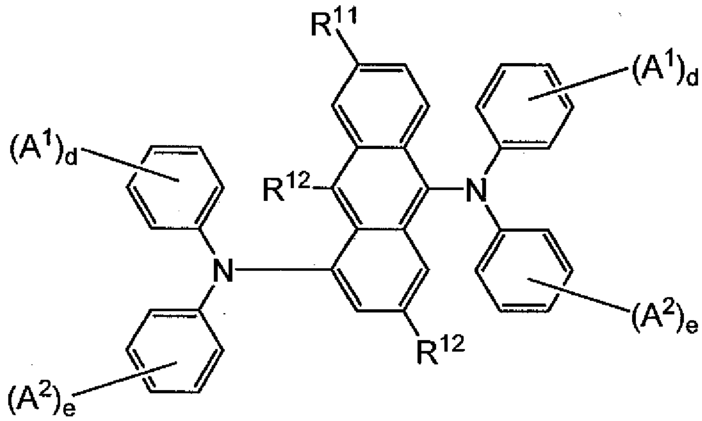

(1-5)

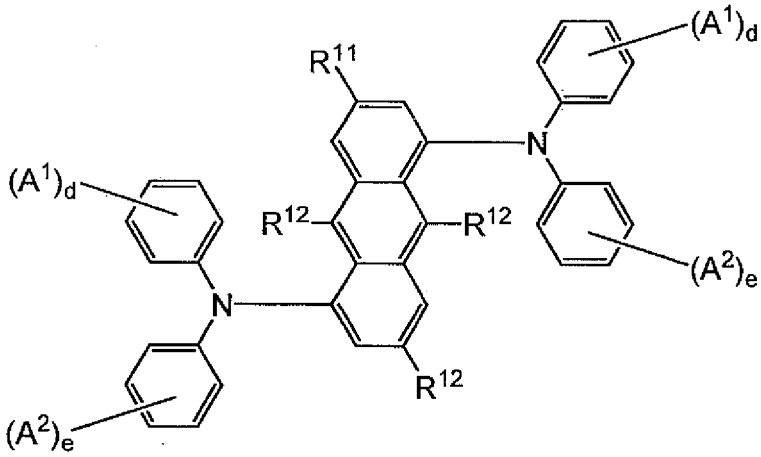

(1-6)

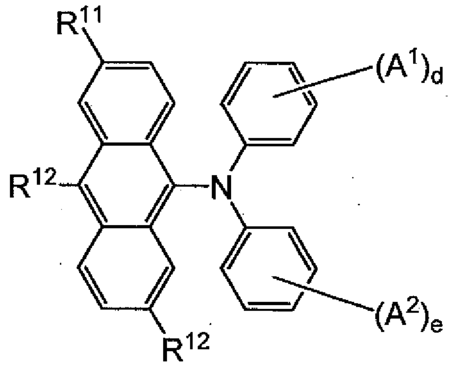

(1-7)

In formulas (1-1) to (1-7), $A^1$, $A^2$, d, e, $R^{11}$ and $R^{12}$ are the same as those in formula (1).

The thickness of the second emitting layer is preferably 1 to 100 nm, more preferably 5 to 50 nm. When it is less than 1 nm, the formation of an emitting layer and the adjustment of chromaticity may become difficult. When it exceeds 100 nm, the driving voltage may increase.

4. Third emitting layer

For color of emitted light, the third emitting layer is preferably a green emitting layer in view of the energy gap relationship. The green emission preferably has a maximum peak wavelength of 500 to 550 nm.
The host material and the dopant mentioned above may be used for the third emitting layer. The host material is preferably the same as that of the second emitting layer.

The thickness of the third emitting layer is preferably 1 to 100 nm, more preferably 5 to 50 nm. When it is less than 1 nm, the formation of an emitting layer and the adjustment of chromaticity may become difficult. When it exceeds 100 nm, the driving voltage may increase.

5. Other organic layers

(1) First organic layer

A hole-injecting layer, a hole-transporting layer, an organic semiconductor layer or the like can be arranged between the anode and the first emitting layer as a first organic layer. The hole-injecting layer or the hole-transporting layer is a layer for helping the injection of holes into the emitting layer so as to transport holes to an emitting region. The hole mobility thereof is large and the ionization energy thereof is usually as small as 5.5 eV or less. A hole-injecting layer is formed to control energy level, for example, to reduce precipitous energy level changes. Such a hole-injecting or hole-transporting layer is preferably made of a material which can transport holes to the emitting layer at a low electric field intensity. The hole mobility thereof is preferably at least $10^{-6}$ $cm^2/V\cdot$second when an electric field of, e.g., $10^4$ to $10^6$ V/cm is applied. Any materials which have the above preferable properties can be used as the material for forming the hole-injecting layer or the hole-transporting layer without particular limitation. The material for forming the hole-injecting layer or the hole-transporting layer can be arbitrarily selected from materials which have been widely used as a material transporting carriers of holes in photoconductive materials and known materials used in a hole-injecting layer of organic EL devices.

Specific examples of materials for a hole-injecting layer and a hole-transporting layer, include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064,

55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive high-molecular oligomers (in particular thiophene oligomers) disclosed in JP-A-1-211399.

The above-mentioned substances can be used as the material of the hole-injecting layer or the hole-transporting layer. The following can also be used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), and aromatic tertiary amine compounds. The following can also be given as examples: 4,4'-bis(N-(1-naphthyl)-N-phenylamino)biphenyl, which has in the molecule thereof two condensed aromatic rings, disclosed in USP No. 5,061,569, and 4,4',4"-tris(N-(3-methylphenyl)-N-phenylamino)triphenylamine, wherein three triphenylamine units are linked to each other in a star-burst form, disclosed in JP-A-4-308688. Inorganic compounds such as aromatic dimethylidene type compounds, mentioned above as the material for an emitting layer, and p-type Si and p-type SiC can also be used as the material of the hole-injecting layer or the hole-transporting layer.

As the hole transporting material, the aromatic amine derivative of the following formula (1) is preferable.

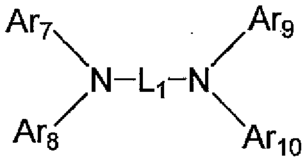

(1)

wherein $L_1$ is a divalent group selected from a substituted or unsubstituted arylene group having 5 to 60 carbon atoms or a heterocyclic group, and $Ar_7$ to $Ar_{10}$ are independently a substituted or unsubstituted substituent having 5 to 50 atoms that form a ring or a substituent of the following formula.

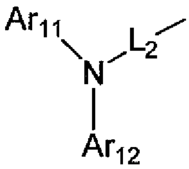

wherein $L_2$ is a divalent group selected from a substituted or unsubstituted arylene group having 5 to 60 carbon atoms or a heterocyclic group, and $Ar_{11}$ and $Ar_{12}$ are independently a substituted or unsubstituted substituents having 5 to 50 atoms that form a ring.

As examples of $L_1$ and $L_2$, biphenylene, terphenylene, phenanthrene, and fluorenylene can be given. Of these, biphenylene and terphenylene are preferable, with biphenylene being still more preferable.

As examples of $Ar_7$ to $Ar_{12}$, a biphenyl group, terphenyl group, phenanthrene group, fluorenyl group, 1-naphthyl group, 2-naphthyl group, and phenyl group can be given. Of these, a biphenyl group, terphenyl group, 1-naphthyl group, and phenyl group are preferable.

In the compound of the formula (1), it is preferable that $Ar_7$ to $Ar_{10}$ be identical substituents. In this case, $Ar_7$ to $Ar_{10}$ are preferably biphenyl groups or terphenyl groups, and still more preferably biphenyl groups.

In the compound of the formula (1), it is preferable that $Ar_8$ to $Ar_{10}$ among $Ar_7$ to $Ar_{10}$ be identical substituents. In this case, $Ar_8$ to $Ar_{10}$ are preferably biphenyl groups or terphenyl groups, and more preferably biphenyl groups, and $Ar_7$ is preferably a biphenyl group, terphenyl group, phenanthrene group, fluorenyl group, 1-naphthyl group, 2-naphthyl group, or phenyl group, and more preferably a biphenyl group, terphenyl group, 1-naphthyl group, or phenyl group. Still more preferably, $Ar_8$ to $Ar_{10}$ are biphenyl groups, and $Ar_7$ is a terphenyl group or a 1-naphthyl group.

In the compound of the formula (1), it is preferable that three or more of $Ar_7$ to $Ar_{10}$ be different substituents. $Ar_7$ to $Ar_{12}$ are preferably a biphenyl group, terphenyl group, phenanthrene group, fluorenyl group, 1-naphthyl group, 2-naphthyl group, or phenyl group, and more preferably a biphenyl group, terphenyl group, 1-naphthyl group, or phenyl group. Still more preferably, $Ar_9$ to $Ar_{10}$ are biphenyl groups, $Ar_7$ is a terphenyl group or a 1-naphthyl group, and $Ar_8$ is a phenyl group.

As the hole injecting layer, a compound of the following formula may be used.

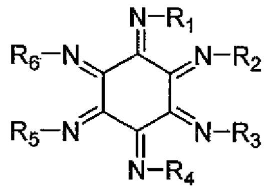

wherein $R_1$, $R_2$, $R_3$, $R_4$, $R_5$, and $R_6$ are independently a substituted or unsubstituted alkyl group, a substituted or unsubstituted aryl group, a substituted or unsubstituted aralkyl group, or a substituted or unsubstituted heterocyclic group. $R_1$, $R_2$, $R_3$, $R_4$, $R_5$, and $R_6$ may be the same or different. $R_1$ and $R_2$, $R_3$ and $R_4$, and $R_5$ and $R_6$, or $R_1$ and $R_6$, $R_2$ and $R_3$, and $R_4$ and $R_5$ may form condensed rings.

The following compound is more preferable.

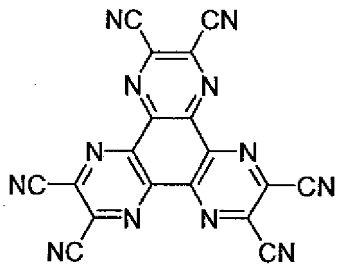

This hole-injecting layer or the hole-transporting layer may be a single layer made of one or more of the above-mentioned materials, or may be stacked hole-injecting layers or hole-transporting layers made of different compounds. The thickness of the hole-injecting layer or the hole-transporting layer is not particularly limited, and is preferably 20 to 200 nm.

The organic semiconductor layer is a layer for helping the injection of holes or electrons into the emitting layer, and is preferably a layer having an electric conductivity of $10^{-10}$ S/cm or more. As the material of such an organic semiconductor layer, electroconductive oligomers such as thiophene-containing oligomers or arylamine-containing oligomers disclosed in JP-A-8-193191, and electroconductive dendrimers such as arylamine-containing dendrimers may be used. The thickness of the organic semiconductor layer is not particularly limited, and is preferably 10 to 1,000 nm.

(2) Second organic layer

An electron-injecting layer, an electron-transporting layer and the like can be arranged between the cathode and the second emitting layer as a second organic layer. The electron-injecting layer or the electron-transporting layer is a layer for helping the injection of electrons into the emitting layer, and has a large electron mobility. The electron-injecting layer is formed to control energy level, for example, to reduce precipitous energy level changes. The material used for the electron-injecting layer or electron-transporting layer is preferably a metal complex of 8-hydroxyquinoline or derivatives thereof, oxadiazole derivatives and nitrogen-containing heterocyclic derivatives. Specific examples of the metal complexes of 8-hydroxyquinoline or derivatives thereof include metal chelate oxynoid compounds containing a chelate of oxine (generally, 8-quinolinol or 8-hydroxyquinoline). For example, tris(8-quinolinol)aluminum can be used. Examples of the oxadiazole derivatives include electron-transporting compounds represented by the following formulas:

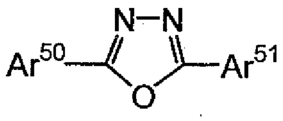

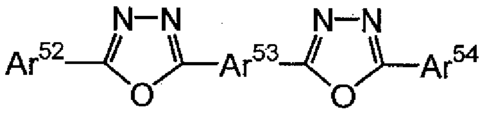

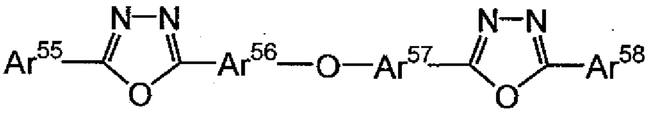

wherein $Ar^{50}$, $Ar^{51}$, $Ar^{52}$, $Ar^{54}$, $Ar^{55}$ and $Ar^{58}$ may be the same or different and each represent a substituted or unsubstituted aryl group; and $Ar^{53}$, $Ar^{56}$ and $Ar^{57}$ are independently a substituted or unsubstituted arylene group and $Ar^{56}$ and $Ar^{57}$ may be the same or different. Examples of the aryl group in these formulas include phenyl, biphenyl, anthranyl, perylenyl, and pyrenyl groups. Examples of the arylene group include phenylene, naphthylene, biphenylene, anthranylene, perylenylene, and pyrenylene groups.

Examples of the substituents for these include alkyl groups with 1 to 10 carbon atoms, alkoxy groups with 1 to 10 carbon atoms, and a cyano group. The electron-transporting compounds are preferably ones from which a thin film can be easily formed. Specific examples of the electron transporting compounds are mentioned below.

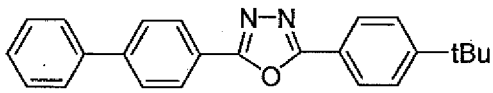

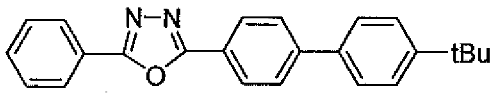

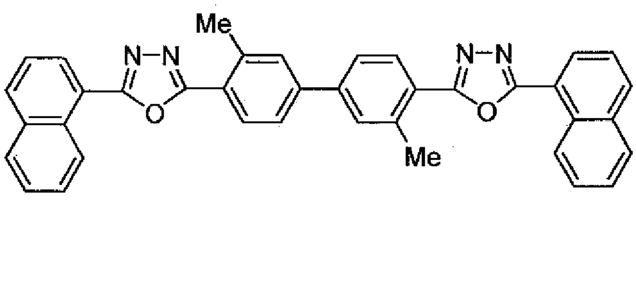

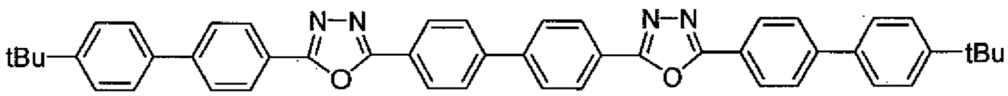

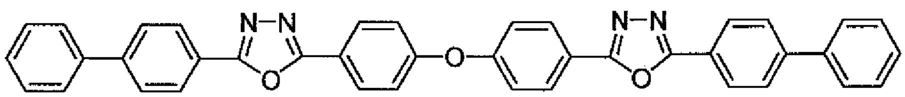

As the nitrogen-containing heterocyclic derivatives, nitrogen-containing compounds having structures illustrated by (a) to (c) and not being metal complexes can be given.

(a) 5-membered or 6-membered ring containing an =N-skeleton.

(b)

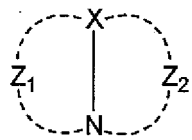

wherein X is a carbon atom or nitrogen atom, and $Z_1$ and $Z_2$ are independently a group of atoms capable of forming a nitrogen-containing heterocycle.

(c)

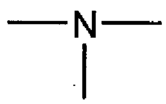

(3)

The nitrogen-containing heterocyclic derivative is preferably an organic compound containing a nitrogen-containing aromatic polycyclic group containing a five-membered ring or six-membered ring, and when the group contains a plurality of nitrogen atoms, the organic compound has a skeleton containing the nitrogen atoms in non-adjacent bonding positions. In the case where the nitrogen-containing aromatic polycyclic group has a plurality of nitrogen atoms, the nitrogen-containing aromatic polycyclic organic compounds having a skeleton with a combination of the above-mentioned (a) and (b), or (a) and (c) can be given.

As the nitrogen-containing heterocyclic derivative, the compounds represented by the following formulas (d) to (g) can be given.

(d) Nitrogen-containing heterocyclic derivatives containing a nitrogen-containing heterocyclic group selected from the following formulas

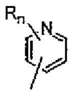 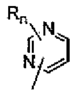 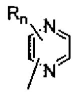 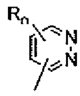 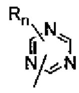 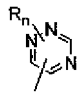

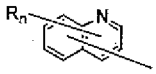 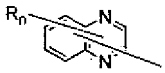 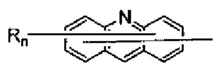

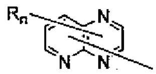 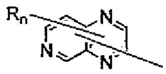 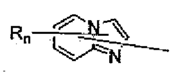

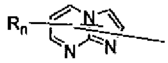 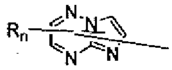 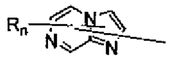

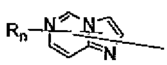 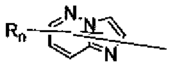 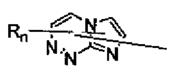

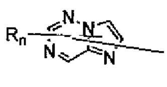 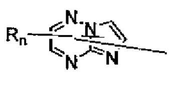 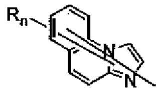

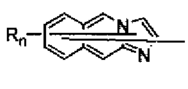 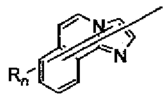

wherein R is an aryl group having 6 to 40 carbon atoms, heteroaryl group having 3 to 40 carbon atoms, alkyl group with 1 to 20 carbon atoms or alkoxy group with 1 to 20 carbon atoms; and n is an integer of 0 to 5. When n is an integer of 2 or more, a plurality of Rs may be the same as or different from each other.

(e) Nitrogen-containing heterocyclic compounds represented by the following formula as a still preferable specific compound:

$$HAr\text{-}L\text{-}Ar^{61}\text{-}Ar^{62}$$

wherein HAr is a substituted or unsubstituted nitrogen-containing heterocyclic ring having 3 to 40 carbon atoms;

L is a single bond, a substituted or unsubstituted arylene group having 6 to 40 carbon atoms, or a substituted or unsubstituted heteroarylene group having 3 to 40 carbon atoms; $Ar^{61}$ is a substituted or unsubstituted bivalent aromatic hydrocarbon group having 6 to 40 carbon atoms; $Ar^{62}$ is a substituted or unsubstituted aryl group having 6 to 40 carbon atoms or a substituted or unsubstituted heteroaryl group having 3 to 40 carbon atoms.

As the HAr, the following groups can be illustrated.

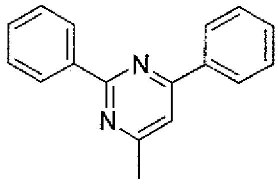 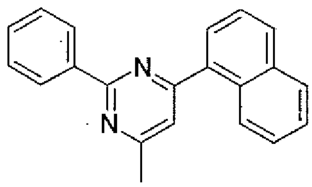 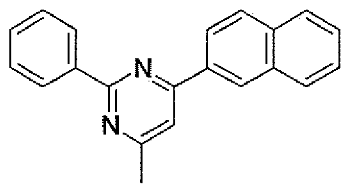

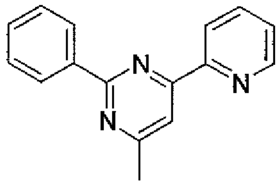 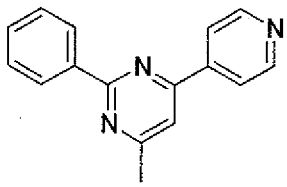 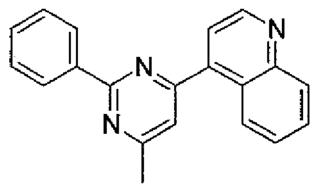

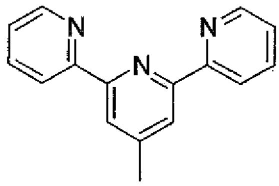 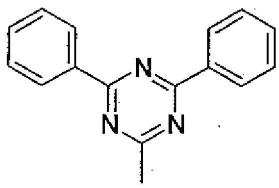 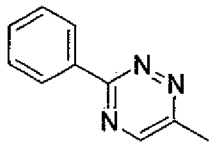

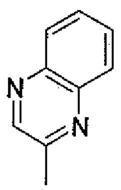 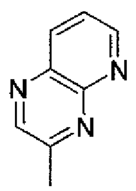 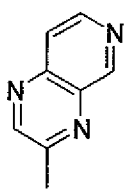 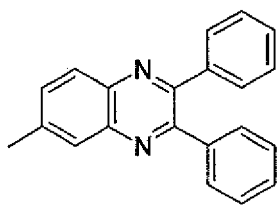

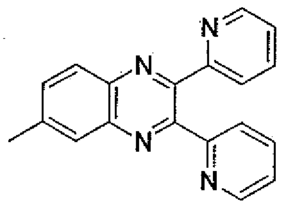 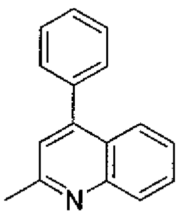 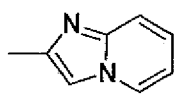 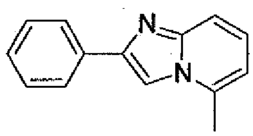

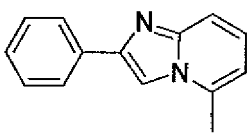 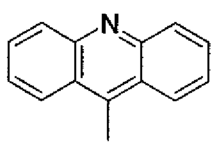 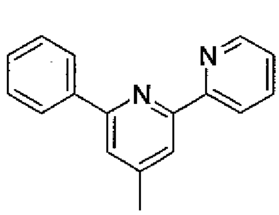

As the L, the following groups can be illustrated.

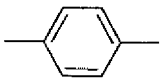 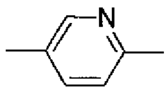

As the $Ar^{62}$, the following groups can be illustrated.

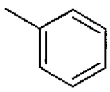 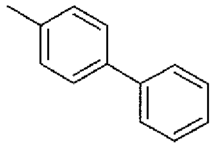 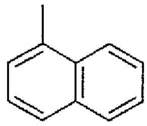 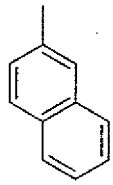

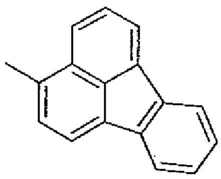 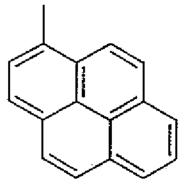 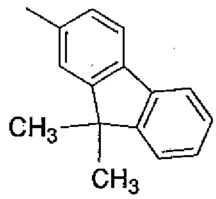

As the $Ar^{61}$, the following groups can be illustrated.

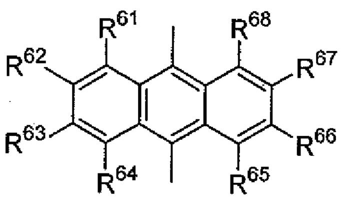 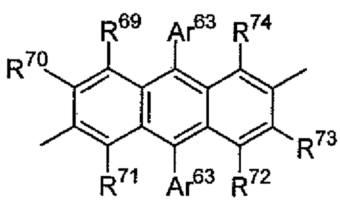

wherein $R^{61}$ to $R^{74}$ are independently a hydrogen atom, halogen atom, alkyl group having 1 to 20 carbon atoms, alkoxy group having 1 to 20 carbon atoms, aryloxy group having 6 to 40 carbon atoms, aryl group having 6 to 40 carbon atoms which may have a substituent or heteroaryl group having 3 to 40 carbon atoms; and $Ar^{63}$s are each an aryl group having 6 to 40 carbon atoms which may have a substituent or heteroaryl group having 3 to 40 carbon atoms.
$R^{61}$ to $R^{74}$ are preferably a hydrogen atom.

(f) Compounds disclosed in JP-A-9-3448

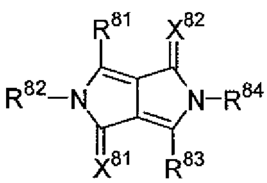

wherein $R^{81}$ to $R^{84}$ are independently a hydrogen atom, a substituted or unsubstituted aliphatic group, a substituted or unsubstituted aliphatic ring group, a substituted or unsubstituted carbocyclic aromatic ring group, or a substituted or unsubstituted heterocyclic group, and $X^{81}$ and $X^{82}$ are independently an oxygen atom, a sulfur atom, or a dicyanomethylene group.

(g) Compounds disclosed in JP-A-2000-173774

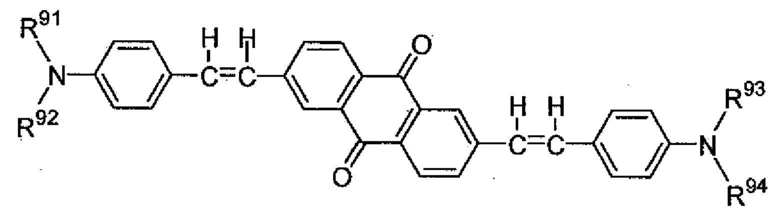

wherein $R^{91}$, $R^{92}$, $R^{93}$, and $R^{94}$, which may be the same or different, are aryl groups of the following formula.

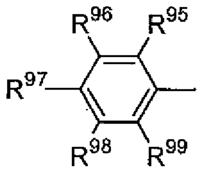

wherein $R^{95}$, $R^{96}$, $R^{97}$, $R^{98}$, and $R^{99}$, which may be the same or different, are a hydrogen atom or af least one of $R^{95}$, $R^{96}$, $R^{97}$, $R^{98}$, and $R^{99}$ is a saturated or unsaturated alkoxy group, alkyl group, amino group, or alkylamino group.

(h) Polymer compounds containing a nitrogen-containing heterocyclic group or nitrogen-containing heterocyclic derivative

The thickness of the electron injecting layer or the electron transporting layer is preferably 1 to 100 nm, although the thickness is not limited thereto.

It is also preferable that the first emitting layer or the first organic layer which is the organic layer closest to the anode contain an oxidizing agent. A preferable oxidizing agent is an electron attracting agent or an electron acceptor. The electron attracting agent or electron acceptor is preferably an organic compound having an electron attracting substituent or an electron-deficient ring.

As examples of the electron attracting substituent, halogen, CN-, carbonyl group, aryl boron group, and the like can be given.

As examples of the electron-deficient ring, a compound selected from group consisting of 2-pyridyl, 3-pyridyl, 4-pyridyl, 2-quinolyl, 3-quinolyl, 4-quinolyl, 2-imidazole, 4-imidazole, 3-pyrazole, 4-pyrazole, pyridazine, pyrimidine, pyrazine, cinnoline, phthalazine, quinazoline, quinoxaline, 3-(1,2,4-N)-triazolyl, 5-(1,2,4-N)-triazolyl, 5-tetrazolyl, 4-(1-0,3-N)-oxazole, 5-(1-0,3-N)-oxazole, 4-(1-S,3-N)-thiazole, 5-(1-S,3-N)-thiazole, 2-benzoxazole, 2-benzothiazole, 4-(1,2,3-N)-benzotriazole, and benzimidazole, and the like can be given. Note that the electron deficient ring is not limited thereto.

Preferred are Lewis acids, various quinone derivatives, dicyanoquinodimethane derivatives, or salts formed by an aromatic amine and Lewis acid.

It is still more preferable to use a quinoid derivative. As examples of the quinoid derivative, compounds of the following formulas (1a) to (1i) can be given. The compounds of the formulas (1a) and (1b) are more preferable.

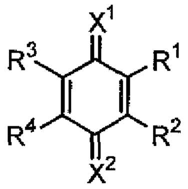
(1a)

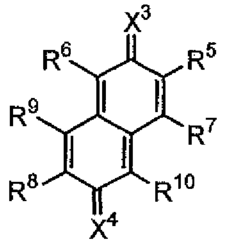
(1b)

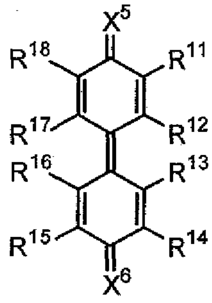
(1c)

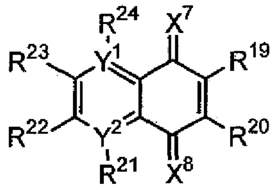
(1d)

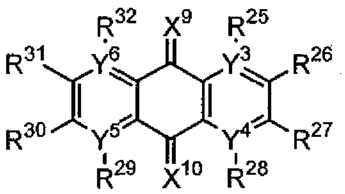
(1e)

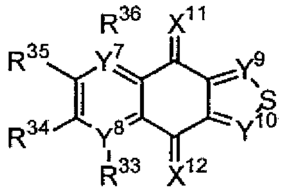
(1f)

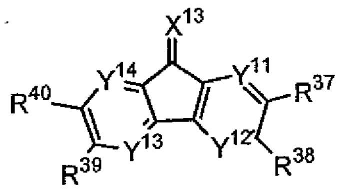
(1g)

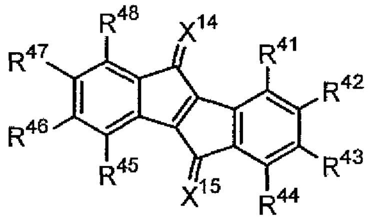
(1h)

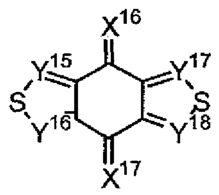
(1i)

In the formulas (1a) to (1i), $R^1$ to $R^{48}$ are independently hydrogen, halogen, a fluoroalkyl group, cyano group, alkoxy group, alkyl group, or aryl group. Hydrogen and a cyano group are preferable.

In the formulas (1a) to (1i), $X^1$ to $X^{17}$ are independently an electron attracting group having one of the structures of the following formulas (j) to (p). The structures of the formulas (j), (k), and (1) are preferable.

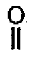
(j)

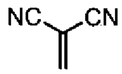
(k)

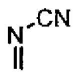
(l)

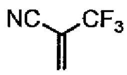
(m)

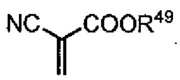
(n)

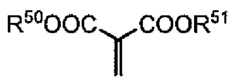
(o)

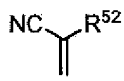
(p)

wherein $R^{49}$ to $R^{52}$ are independently are hydrogen, a fluoroalkyl group, alkyl group, aryl group, or heterocyclic ring, provided that $R^{50}$ and $R^{51}$ may form a ring.

In the formulas (1a) to (1i), $Y^1$ to $Y^{28}$ are independently -N= or -CH=.

As the halogen represented by $R^1$ to $R^{48}$, fluorine and chlorine are preferable.

As the fluoroalkyl group represented by $R^1$ to $R^{48}$, a trifluoromethyl group and a pentafluoroethyl group are preferable.

As the alkoxy group represented by $R^1$ to $R^{48}$, a methoxy group, ethoxy group, iso-propoxy group, and tert-butoxy group are preferable.

As the alkyl group represented by $R^1$ to $R^4$), a methyl group, ethyl group, propyl group, iso-propyl group, tert-butyl group, and cyclohexyl group are preferable.
As the aryl group represented by $R^1$ to $R^{48}$, a phenyl group and a naphthyl group are preferable.
The fluoroalkyl group, alkyl group, and aryl group represented by $R^{49}$ to $R^{52}$ are the same as those of $R^1$ to $R^{48}$.

As the heterocyclic ring represented by $R^{49}$ to $R^{52}$, substituents of the following formulas are preferable.

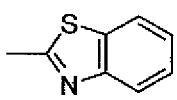
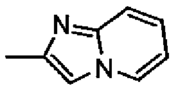
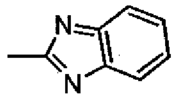

When $R^{50}$ and $R^{51}$ form a ring, X is preferably a substituent of the following formula.

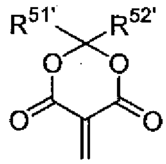

wherein $R^{51'}$ and $R^{52'}$ are independently a methyl group, ethyl group, propyl group, or tert-butyl group.

As specific examples of the quinoid derivative, the following compounds can be given.

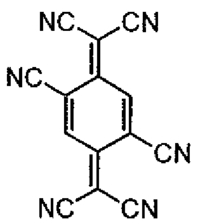

(CN)$_2$-TCNQ

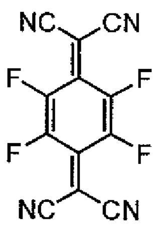
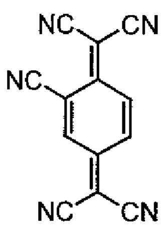
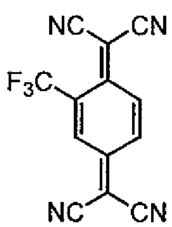
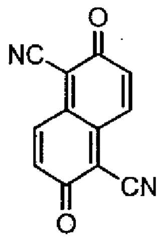
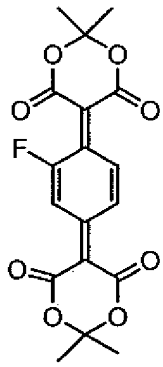

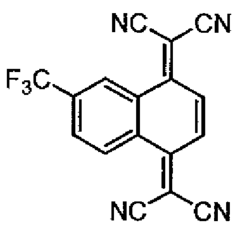
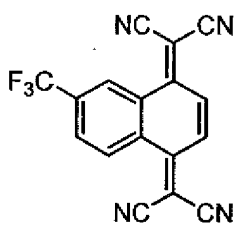
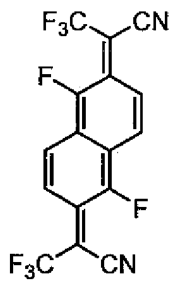
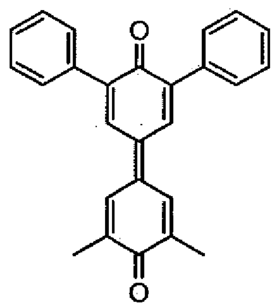

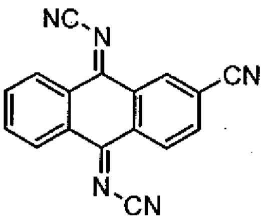
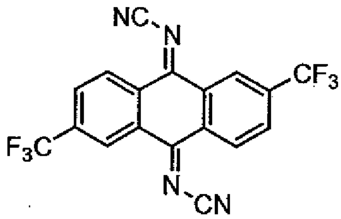
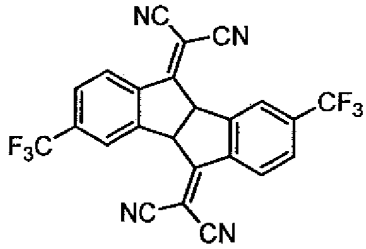

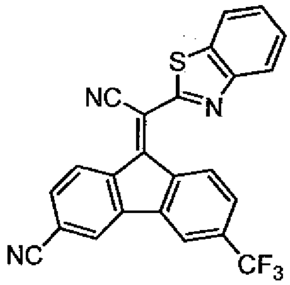
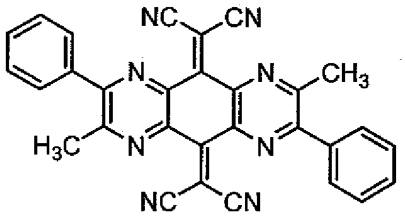
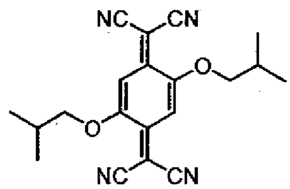

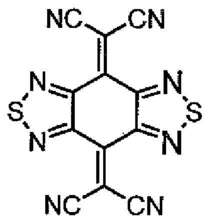

The second emitting layer or second organic layer that is the layer closest to a cathode preferably contains a reducing agent. Preferable reducing agents are alkali metals, alkaline earth metals, oxides of alkali metals, oxides of alkaline earth metals, oxides of rare earth metals, halides of alkali metals, halides of alkaline earth metals, halides of rare earth metals, and complexes formed of alkali metals and aromatic compounds. Particularly preferred alkali metals are Cs, Li, Na and K.

In the invention, the hole transporting layer (hole injecting layer) is preferably formed of the same material as the material used for the carrier blocking layer mentioned above. This is advantageous in the industrial production cost since the kinds of the materials used for the organic EL device can be reduced.

EXAMPLES

The compounds used in the examples and the comparative examples are illustrated below.

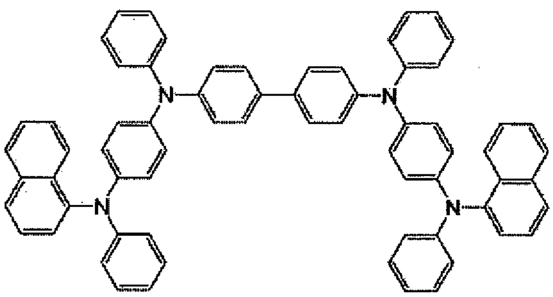

HI

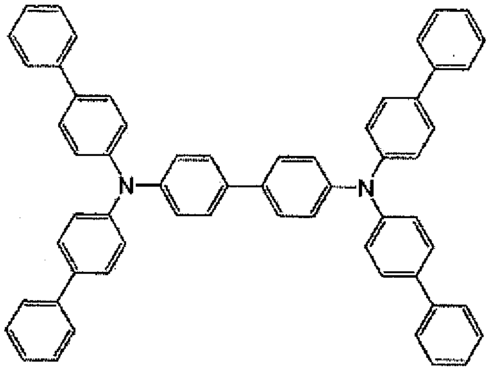

HT

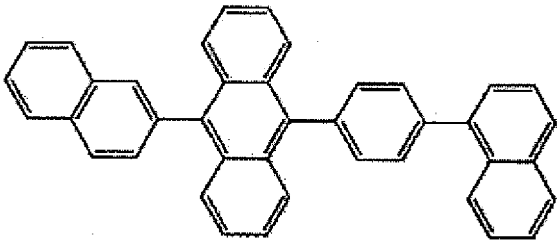

BH

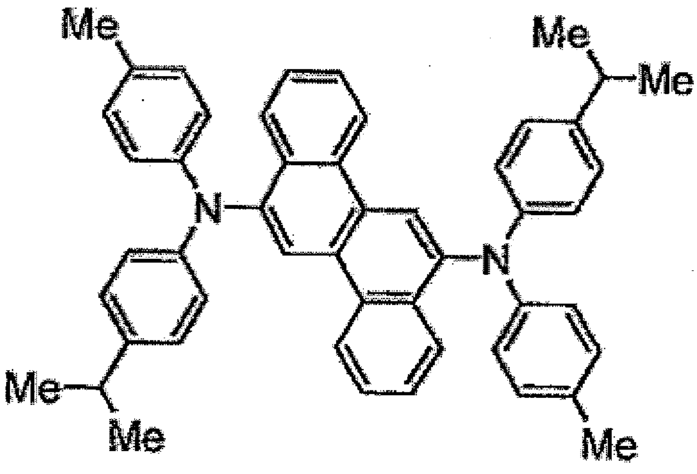

BD

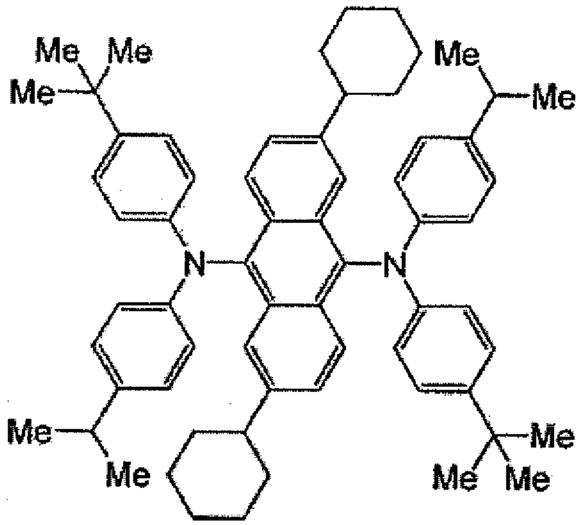

GD

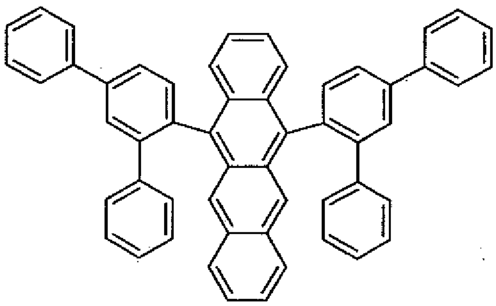

RH

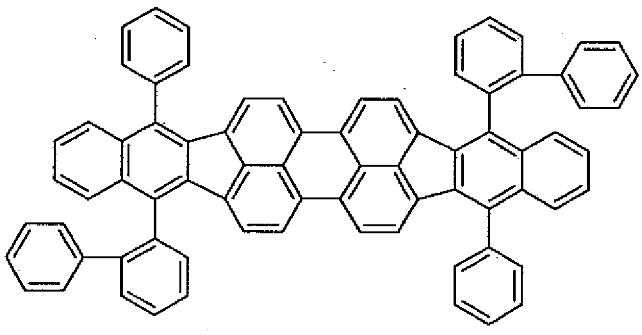

RD

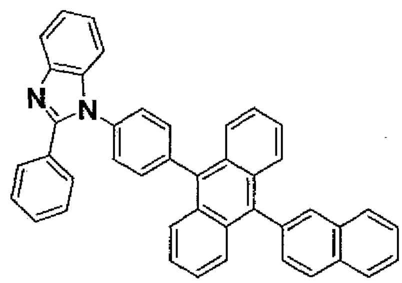

ET

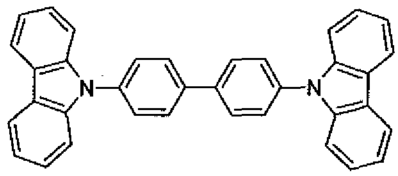

CBP

The energy gap (Eg), ionization potential (Ip) and affinity level (Af) of the above compounds are shown in Table 1.

TABLE 1

| Compound | IP (eV) | Eg (eV) | Af (eV) |
|---|---|---|---|
| BH | 5.8 | 3.0 | 2.8 |
| BD | 5.5 | 2.8 | 2.7 |
| GD | 5.6 | 2.5 | 3.1 |
| RH | 5.6 | 2.4 | 3.2 |
| RD | 5.5 | 2.1 | 3.4 |
| ET | 5.71 | 2.98 | 2.73 |
| HT | 5.36 | 3.06 | 2.3 |
| HI | 5.3 | 3.3 | 2.0 |
| CBP | 5.86 | 3.45 | 2.41 |

Methods for measuring properties of compounds are described below.

(1) Energy gap (Eg)

A solution of a material (solvent: toluene) was measured for ultraviolet-visible light absorption spectra with an ultraviolet-visible light spectrophotometer (UV-3100PC, manufactured by Shimadzu Corporation). An optical band gap was calculated from the long wavelength side tangent line thereof. The optical band gap was taken as Energy gap (Eg).

(2) Ionization potential (IP)

Measured in atmosphere with a photoelectron spectrometer (AC-1, manufactured by Riken Keiki Co., Ltd.). Photoelectrons released were plotted at 1/2 fractional power relative to the energy of ultraviolet ray with which a material (powder) was irradiated, and the threshold value of photoelectron release energy was taken as IP.

(3) Affinity level (Af)

$$Af = Ip - Eg.$$

(4) Driving voltage

A voltage (unit: V) which was applied between ITO and Al such that the current density was 10 mA/cm$^2$ was measured.

(5) Luminance efficiency

Luminance efficiency (unit: cd/A) was calculated from an EL spectrum at the current density of 10 mA/cm$^2$ measured with a spectroradiometer (CS-1000A, manufactured by Konica Minolta Holdings, Inc.)

(6) CIE 1931 chromaticity

CIE 1931 chromaticity (x, y) was calculated from an EL spectrum at the current density of 10 mA/cm$^2$ measured with a spectroradiometer (CS-1000A, manufactured by Konica Minolta Holdings, Inc.).

(7) External quantum efficiency

External quantum efficiency was calculated from an EL spectrum at the current density of 10 mA/cm$^2$ measured with a spectroradiometer (CS-1000A, manufactured by Konica Minolta Holdings, Inc.) on the basis of the following formula:

$$EQE(\%) = \frac{\int(\int(\text{Spectral radiant intensity / Energy of photon})d\lambda)d\Omega}{\text{Current density / Elementary charge of electron}}$$

λ: wavelength of photon
Ω: solid angle

Example 1

(Fabrication of organic EL device)

A glass substrate of 25 mm by 75 mm by 1.1 mm thick with an ITO transparent electrode (anode) (GEOMATEC Co., Ltd.) (thickness of ITO was 130 nm) was subjected to ultrasonic cleaning with isopropyl alcohol for 5 minutes, and cleaned with ultraviolet rays and ozone for 30 minutes. The resultant substrate with transparent electrode lines was mounted on a substrate holder in a vacuum deposition device. First, an HI film was formed in a thickness of 60 nm so as to cover the surface of the transparence electrode on which the transparence electrode lines were formed. This HI film functioned as a hole-injecting layer. After forming the HI film, an HT film was formed in a thickness of 15 nm on the HI film. This HT film functioned as a hole-transporting layer.

Following the formation of the HT film, RH (Eg: 2.4 eV) and RD were deposited to a thickness of 5 nm to form a first emitting layer (Ip/Af [eV] = 5.6/3.2) such that the concentration of RD was 0.5 wt%. The first emitting layer emits red light. Next, as a carrier blocking layer, an HT film (Ip/Af [eV] = 5.36/2.3) was formed in a thickness of 5 nm. BH and BD were deposited to a thickness of 40 nm to form a blue emitting layer (second emitting layer) (Ip/Af [eV] = 5.8/2.8) thereon such that the concentration of BD was 7.5 wt%. As an electron-transporting layer, a 20 nm thick tris(8-quinolinol) aluminum film ($Alq_3$ film) was formed thereon. Thereafter, an LiF film was formed in a thickness of 1.6 nm as an electron-injecting layer and metal Al was deposited in a thickness of 150 nm as a metal cathode, thereby fabricating an organic EL device.

(Evaluation of organic EL device)

The energy levels of the first emitting layer, first carrier blocking layer and the second emitting layer formed in Example 1 are shown in FIG. 5. The properties of the organic EL device obtained were measured. The results are shown in Table 2.

Comparative Example 1

An organic EL device was fabricated in the same way as in Example 1 except that after forming the first emitting layer, the carrier blocking layer was not formed. The organic EL device obtained was measured in the same way as in Example 1. The results are shown in Table 2.

Comparative Example 2

An organic EL device was fabricated in the same way as in Comparative Example 1 except that the thickness of the hole transporting layer was changed to 10 nm, the thickness of the first emitting layer was changed to 40 nm, the thickness of the electron transporting layer was changed to 30 nm and the second emitting layer was not formed. The organic EL device obtained was measured in the same way as in Example 1. The results are shown in Table 2.

Comparative Example 3

An organic EL device was fabricated in the same way as in Comparative Example 1 except that the thickness of the hole transporting layer was changed to 20 nm, the thickness of the second emitting layer was changed to 40 nm and the first emitting layer was not formed. The organic EL device obtained was measured in the same way as in Example 1. The results are shown in Table 2.

Comparative Example 4

An organic EL apparatus was fabricated in the same way as in Example 1 except that as the carrier blocking layer, an ET film (Ip/Af [eV] = 5.71/2.73) was formed instead of the HT film in a thickness of 5 nm. FIG. 6 shows the energy levels of the first emitting layer, first carrier blocking layer, and second emitting layer formed in Comparative Example 4. The organic EL device obtained was measured in the same way as in Example 1. The results are shown in Table 2.

Example 2

An organic EL device was fabricated in the same way as in Example 1 except that after forming the second emitting layer in a thickness of 10 nm, as a third emitting layer, BH and GD were deposited to a thickness of 30 nm to form a green emitting layer (Ip/Af [eV] = 5.8/2.8) such that the concentration of GD was 10 wt% and then the $Alq_3$ layer (electron transporting layer) was formed. The organic EL device obtained was measured in the same way as in Example 1. The results are shown in Table 2.

Comparative Example 5

An organic EL device was fabricated in the same way as in Example 2 except that as the carrier blocking layer, a CBP film (Ip/Af [eV] = 5.86/2.41) was formed instead of the HT film in a thickness of 5 nm. FIG. 7 shows the energy levels of the first emitting layer, first carrier blocking layer, and second emitting layer formed in Comparative Example 5. The organic EL device obtained was measured in the same way as in Example 1. The results are shown in Table 2.

Example 3

An organic EL device was fabricated in the same way as in Example 1 except that as the carrier blocking layer, HT and GD were deposited instead of HT to form a layer (Ip/Af [eV] = 5.36/2.3) such that the concentration of GD was 10 wt%, and the thickness of the second emitting layer was changed to 40 nm.
The organic EL device obtained was measured in the same way as in Example 1. The results are shown in Table 2.

Example 4

An organic EL device was fabricated in the same way as in Example 2 except that as the carrier blocking layer, HT and GD was deposited instead of HT to form a layer (Ip/Af [eV] = 5.36/2.3) such that the concentration of GD was 5 wt%, the thickness of the second emitting layer was changed to 15 nm and the thickness of the third emitting layer was changed to 25 nm.
The organic EL device obtained was measured in the same way as in Example 1. The results are shown in Table 2.
TABLE 2

| | First emitting layer<br>Ip/Af(eV) | First carrier blocking layer<br>Ip/Af(eV) | Second emitting layer<br>Ip/Af(eV) | Third emitting layer<br>Ip/Af(eV) | Voltage<br>V | Chromaticity<br>x | Chromaticity<br>y | L/J<br>cd/A | External quantum efficiency<br>% |
|---|---|---|---|---|---|---|---|---|---|
| Example 1 | RH:RD<br>5.6/3.2 | HT<br>5.36/2.3 | BH:BD<br>5.8/2.8 | - | 7.2 | 0.27 | 0.26 | 11.6 | 7.6 |
| Comparative example 1 | RH:RD<br>5.6/3.2 | - | BH:BD<br>5.8/2.8 | - | 7.6 | 0.50 | 0.31 | 10.4 | 8.0 |
| Comparative example 2 | RH:RD<br>5.6/3.2 | - | - | - | 5.2 | 0.65 | 0.34 | 8.2 | 6.4 |
| Comparative example 3 | - | - | BH:BD<br>5.8/2.8 | - | 7.2 | 0.14 | 0.19 | 8.8 | 6.3 |
| Comparative example 4 | RH:RD<br>5.6/3.2 | ET<br>5.71/2.73 | BH:BD<br>5.8/2.8 | - | 7.8 | 0.55 | 0.32 | 7.4 | 5.8 |
| Example 2 | RH:RD<br>5.6/3.2 | HT<br>5.36/2.3 | BH:BD<br>5.8/2.8 | BH:GD<br>5.8/2.8 | 7.3 | 0.32 | 0.39 | 16.7 | 7.7 |
| Comparative example 5 | RH:RD<br>5.6/3.2 | CBP<br>5.86/2.41 | BH:BD<br>5.8/2.8 | BH:GD<br>5.8/2.8 | 7.5 | 0.45 | 0.43 | 15 | 7.1 |
| Example 3 | RH:RD<br>5.6/3.2 | HT:GD<br>5.36/2.3 | BH:BD<br>5.8/2.8 | - | 6.9 | 0.32 | 0.33 | 14 | 7.8 |
| Example 4 | RH:RD<br>5.6/3.2 | HT:GD<br>5.36/2.3 | BH:BD<br>5.8/2.8 | BH:GD<br>5.8/2.8 | 7.1 | 0.35 | 0.41 | 16.6 | 7.5 |

In Example 1, the red emission of Comparative example 2 and the blue emission of Comparative example 3 were combined. A red emitting layer with a small energy gap was used as the first emitting layer on the anode side, a blue emitting layer with a large energy gap was used as the second emitting layer, and a carrier blocking layer with a small affinity level was provided therebetween. As a result, excellent white emission could be obtained whose external quantum efficiency was higher than those of individual colors (FIG. 5).
In Example 2, the addition of a green emitting layer as the third emitting layer to the device of Example 1 gave excellent white emission with a similar external quantum efficiency and higher luminance efficiency.
In Example 3, doping the carrier blocking layer of Example 1 with a green emission material gave excellent white emission with a similar external quantum efficiency.
In Comparative example 4, since the electron transporting, carrier blocking layer with a large affinity level was provided, red became strong and the efficiency was reduced (FIG. 6).
In Comparative example 5, since the carrier blocking layer with a large ionization potential and small affinity level was provided, holes remained in the first emitting layer so that red became strong compared to Example 2 and excellent white emission could not be obtained (FIG. 7).
In Comparative example 1, the CIE1931 chromaticity (x, y) was significantly apart from white (0.33, 0.33) in the luminance range of 10 to 10000 cd/$m^2$ so that red became strong and excellent white emission could not be obtained. In Examples 1 to 4, the chromaticity (x, y) was close to white and excellent white emission was obtained. In particular, in Example 3, a change in chromaticity (x, y) in the luminance range of 10 to 10000 cd/$m^2$ was smaller than those in Examples 1 to 2 and 4 and more excellent white emission could be obtained (FIGS. 8 and 9).

Comparative Example 6

An organic EL device was fabricated in the same way as in Example 1 except that the compositions of the first emitting layer, the electron blocking layer and the second emitting layer were changed to those shown in Table 3. That is, the red emitting layer was provided on the cathode side of the carrier blocking layer, and as the carrier blocking layer, an amine hole transporting material (GD) with an affinity level of 3.1 eV was used. The organic EL device obtained was measured in the same way as in Example 1. The results of the measurement are shown in Table 3.
The CIE1931 chromaticity coordinates (x, y) were (0.657, 0.340), showing only the second emitting layer emitted red light. The luminous efficiency was poor.

Comparative Example 7

An organic EL device was fabricated in the same way as in Example 1 except that the compositions of the first emitting layer and the second emitting layer were changed to those shown in Table 3. That is, the red emitting layer was provided on the cathode side of the carrier blocking layer as in Comparative Example 6 given above. Here, the affinity level of the host material of the first emitting layer was higher than the affinity level of the carrier blocking layer. For the resulting organic EL device, the measurement was conducted in the same way as in Example 1. The results of the measurement are shown in Table 3.
The chromaticity coordinates (x, y) were (0.657, 0.340), showing only the second emitting layer emitted red light. The luminous efficiency was poor. In this case, only red emission was obtained, and no electrons were injected to the first emitting layer (blue), whereby good white emission was not obtained.
From the above two comparative examples, if the energy gap of the host material of the second emitting layer is smaller than the energy gap of the first emitting layer, well-balanced emission cannot be obtained irrespective of the affinity level of the carrier blocking layer.
Therefore, the energy gap of the second emitting layer needs to be larger than the.energy gap of the first emitting layer.

Comparative Example 8

An organic EL device was fabricated in the same manner as in Example 1 except that the compositions of the first emitting layer, the electron blocking layer and the second emitting layer were changed to those shown in Table 3. That is, the first emitting layer was rendered the green emitting layer and the second emitting layer was rendered the blue emitting layer. The carrier blocking layer was doped with a red dopant (RD). For the resulting organic EL device, the measurement was conducted in the same way as in Example 1. The results obtained are shown in Table 3.
From the chromaticity data, the recombination energy at the interface of the carrier blocking layer and the second emitting layer was transferred to the blue dopant and the red dopant to cause emission. However, since energy was not transferred from the red dopant to the green dopant, almost no green emission was observed.

Comparative Example 9

An organic EL device was fabricated in the same manner as in Example 1 except that the compositions of the first emitting layer, the electron blocking layer and the second emitting layer were changed to those shown in Table 3. That is, the first emitting layer was rendered the blue emitting layer and the second emitting layer was rendered the red emitting layer. The carrier blocking layer was doped with a green dopant. For the resulting organic EL device, the measurement was conducted in the same way as in Example 1. The results obtained are shown in Table 3.
As is apparent from the chromaticity data, the color of emitted light was almost red.
As shown in Example 3 and Comparative Examples 8 and 9, to obtain a well-balanced 3-wavelength white, it is preferred that blue of which the emission is weak be arranged in the region where the recombination most occurs. Therefore, the second emitting layer is rendered the blue emitting layer. In view of the balance of the host material, the first emitting layer is rendered the red emitting layer. Due to this configuration, well-balanced white color can be obtained. Further, by doping the carrier blocking layer with a green dopant, green emission can be obtained by the exciton energy generated in the interface region between the carrier blocking layer and the second emitting layer. In addition, since the carrier blocking layer, which has the recombination zones at the interfaces with the first emitting layer and the second emitting layer, is doped with green, it is possible to obtain green emission stably. Since green has high luminosity, human eyes easily recognize if emission balance thereof changes. Therefore, white color which hardly suffers from color shift can be obtained by arranging green in the region where emission balance can be attained most easily.

Example 5

An organic EL device was fabricated in the same manner as in Example 2 except that the compositions of the second emitting layer and the third emitting layer were changed to those shown in Table 3. For the resulting organic EL device, measurement was conducted in the same way as in Example 1. The results are shown in Table 3.
As is apparent from the chromaticity data, blue emission at a wavelength of about 460 nm was weak, and therefore good white emission could not be obtained. The reason therefore is that, although carriers are recombined in the vicinity of the interface of the carrier blocking layer and the second emission layer (green) to emit green light, the energy is hardly transferred to the blue emitting layer, only producing weak blue emission.
As is apparent from the comparison between Example 2 and Example 5, in Example 2, the recombination energy in the second emitting layer was transferred to the third emitting layer to cause the green emitting material in the third emitting layer to emit light. In Example 2, since green was arranged nearer to the cathode as compared with blue, it was possible to attain well-balanced electron injection for blue. This is because the green dopant acts as the electron trap. As a result, a device configuration which attains well-balanced white color emission as a whole can be realized.
TABLE 3

| | First emitting layer<br><br>Ip/Af(eV) | First carrier blocking layer<br>Ip/Af(eV) | Second emitting layer<br>Ip/Af(eV) | Third emitting layer<br><br>Ip/Af(eV) | Chromaticity<br><br>x | Chromaticity<br><br>y | L/J<br><br>cd/A | External quantum efficiency<br>% |
|---|---|---|---|---|---|---|---|---|
| Comparative example 6 | BH:BD<br>5.8/2.8 | GD<br>5.6/3.1 | RH:RD<br>5.6/3.2 | - | 0.657 | 0.340 | 6.26 | 4.88 |
| Comparative example 7 | BH:BD<br>5.8/2.8 | HT<br>5.36/2.3 | RH:RD<br>5.6/3.2 | - | 0.657 | 0.340 | 6.76 | 5.28 |
| Comparative example 8 | BH:GD<br>5.8/2.8 | HT:RD<br>5.36/2.3 | BH:BD<br>5.8/2.8 | - | 0.245 | 0.227 | 8.51 | 6.15 |
| Comparative example 9 | BH:BD<br>5.8/2.8 | HT:GD<br>5.36/2.3 | RH:RD<br>5.6/3.2 | - | 0.658 | 0.339 | 6.84 | 5.40 |
| Example 5 | RH:RD<br>5.6/3.2 | HT<br>5.36/2.3 | BH:GD<br>5.8/2.8 | BH:BD<br>5.8/2.8 | 0.376 | 0.508 | 17.92 | 6.44 |

Example 6

(Full-color emitting apparatus)

A black matrix (BM) material, V259BK (manufactured by Nippon Steel Chemical Co., Ltd.), was spin-coated on a supporting substrate of 112mm by 143mm by 1.1mm (OA2 glass, manufactured by Nippon Electric Glass Co., Ltd.). The substrate was exposed to ultraviolet rays through a photomask for forming a lattice-like pattern with openings of 68 μm by 285 μm, developed with a 2% aqueous solution of sodium carbonate and baked at 200°C to form a pattern of a black matrix (film thickness 1.5 μm).

Next, a blue filter material, V259B (manufactured by Nippon Steel Chemical Co., Ltd.), was spin-coated. The resultant substrate was exposed to ultraviolet rays through a photomask for forming a pattern of 320 rectangle stripes (100 μm line, 230 μm gap) in alignment with the position of the black matrix, developed with a 2% aqueous solution of sodium carbonate and baked at 200°C to form the pattern of a blue filter (film thickness 1.5 μm).

Next, a green filter material, V259G (manufactured by Nippon Steel Chemical Co., Ltd.) was spin-coated. The resultant substrate was exposed to ultraviolet rays through a photomask for forming a pattern of 320 rectangle stripes (100 μm line, 230 μm gap) in alignment with the position of the black matrix, developed with a 2% aqueous solution of sodium carbonate and baked at 200°C to form a pattern of a green filter (film thickness 1.5 μm) adjacent the blue filter.

Next, a red filter material, CRY-S840B (manufactured by FUJIFILM Arch Co., Ltd.), was spin-coated. The resultant substrate was exposed to ultraviolet rays through a photomask for forming a pattern of 320 rectangle stripes (100 μm line, 230 μm gap) in alignment with the position of the black matrix, developed with a 2% aqueous solution of sodium carbonate and baked at 200°C to form a pattern of a red filter (film thickness 1.5 μm) between the blue filter and the green filter.

Next, an acrylic thermosetting resin (V259PH, manufactured by Nippon Steel Chemical Co., Ltd.) was spin-coated on the above substrate as a flattening film and baked at 180°C to form a 5 μm-thick flattening film.
An IZO (indium zinc oxide) film was then formed by sputtering in a thickness of 130 nm.

A positive resist (HPR204, manufactured by FUJIFILM OLIN) was spin-coated on the substrate. The resultant substrate was exposed to ultraviolet rays through a photomask for forming a stripe-like pattern with a 90 μm line and 20 μm gap, and a part for taking out cathode, developed with a developer of tetramethyl ammonium hydroxide, and baked at 130°C to obtain a resist pattern.

Next, ITO in the exposed parts was etched with an ITO etchant. The resist was processed with a release liquid mainly containing ethanolamine (N303: manufactured by NAGASE & Co., Ltd.) to produce an ITO pattern (lower electrode: anode, 960 lines) in positions corresponding to the blue filter, the green filter and the red filter.

Next, a negative resist (V259PA, manufactured by Nippon Steel Chemical Co., Ltd.) was spin-coated as a first inter-insulating film. The result was exposed to ultraviolet rays through a photomask, developed with a developer of tetramethyl ammonium hydroxide, and baked at 180°C to obtain an inter-insulating film of lattice-like pattern coating edges of ITO. The opening of ITO was 70 μm by 290 μm.

Next, a negative resist (ZPN1100, manufactured by ZEON Corporation) was spin-coated as a second inter-insulating film (separator walls). The result was exposed to ultraviolet rays through a photomask for forming a stripe pattern with a 20 μm line and 310 μm gap, and thereafter baked. The negative resist was developed with a developer of tetramethyl ammonium hydroxide to obtain a second inter-insulating film (separator walls) which is in a direction perpendicular to the ITO stripes.
The substrate thus obtained was subjected to ultrasonic cleaning with purified water and isopropyl alcohol, dried with air blow and thereafter cleaned with ultraviolet rays.

The organic layers (hole injecting layer to electron injecting layer) were deposited with a mask in the region covering color filters. The cathode was deposited with a mask so as to connect with an electrode for taking out ITO, which electrode had been previously formed. The cathode (upper electrode) was automatically separated by the separator walls that had been formed on the substrate to form a pattern intersecting lower electrodes (240 lines).

The organic EL element thus formed on the substrate was moved in a dry box through which dried nitrogen flowed without contacting the atmosphere. In this dry box, a display part was covered with a sealing substrate of glass plate and a cation curable adhesive (TB3102, manufactured by Three Bond Co., Ltd.) was photo-cured in the periphery of the display part for sealing.

As stated above, a full-color emission apparatus was produced where lower and upper electrodes formed an XY matrix. When a DC voltage was applied across the lower and upper electrodes (lower electrode: (+), upper electrode: (-)), the intersections of electrodes (pixels) each emitted light.

(Evaluation of properties of full-color emitting apparatus)

(1) Blue color performance

As a result of application of a DC voltage of 7.25 V between the lower electrode and the upper transparent electrode corresponding to the blue color filter, blue emission was obtained. The blue emission was measured by means of a spectroradiometer (CS-1000, manufactured by Konica Minolta Holdings, Inc.), and as a result, it was found that the luminance was 31 cd/$m^2$ and the chromaticity coordinates were (0.124, 0.117). The luminous efficiency was calculated by measuring the value of current flowing between these electrodes, and found to be 1.14 cd/A.

(2) Green color performance

As a result of application of a DC voltage of 7.25 V between the lower electrode and the upper transparent electrode corresponding to the green color filter, green emission was obtained. The green emission was measured by means of a spectroradiometer (CS-1000, manufactured by Konica Minolta Holdings, Inc.), and as a result, it was found that the luminance was 250 cd/$m^2$ and the chromaticity coordinates were (0.247, 0.621). The luminous efficiency was calculated by measuring the value of current flowing between these electrodes, and found to be 9.24 cd/A.

(3) Red color performance

As a result of application of a DC voltage of 7.25 V between the lower electrode and the upper transparent electrode corresponding to the red color filter, red emission was obtained. The red emission was measured by means of a spectroradiometer (CS-1000, manufactured by Konica Minolta Holdings, Inc.), and as a result, it was found that the luminance was 85 cd/$m^2$ and the chromaticity coordinates were (0.652, 0.335). The luminous efficiency was calculated by measuring the value of current flowing between these electrodes, and found to be 3.15 cd/A.

(4) Entire surface lightening

As a result of application of a DC voltage of 7.25 V between all lower electrodes and all upper electrodes, white emission was observed. The white emission was measured by means of a spectroradiometer (CS-1000, manufactured by Konica Minolta Holdings, Inc.), and as a result, it was found that the luminance was 451 cd/$m^2$ and the chromaticity coordinates were (0.324, 0.397). The luminous efficiency was calculated by measuring the value of current flowing between these electrodes, and found to be as high as 4.51 cd/A.

INDUSTRIAL APPLICABILITY

The organic EL device of the invention can be used for various displays, backlight, full-color displays with color filters, and light sources for general and special lighting.

## Claims

**1.** An organic electroluminescence device comprising:

an anode, a first emitting layer, a carrier blocking layer, a second emitting layer, and a cathode stacked in that order;
the first emitting layer and the second emitting layer each containing a host material and a dopant;
the energy gap of the host material of the first emitting layer being smaller than the energy gap of the host material of the second emitting layer;
the host material of the first emitting layer being a hole transporting material, and the host material of the second emitting layer being an electron transporting material;
the affinity level of the carrier blocking layer being smaller than the affinity level of the host material of the second emitting layer in an amount of 0.2 eV or more; and
the ionization potential (Ie1) of the carrier blocking layer and the ionization potential (Ih1) of the host material of the first emitting layer satisfying the following relationship (1):

$$Ie1<Ih1+0.1\ (eV) \qquad (1)$$

2. An organic electroluminescence device comprising:

an anode, a first emitting layer, a carrier blocking layer, a second emitting layer, a third emitting layer, and a cathode stacked in that order;
the first emitting layer, the second emitting layer and the third emitting layer each containing a host material and a dopant;
the energy gap of the host material of the first emitting layer being smaller than the energy gap of the host material of the second emitting layer;
the host material of the first emitting layer being a hole transporting material;
the host materials of the second and third emitting layers being electron transporting materials;
the carrier blocking layer being a hole transporting material; and
the ionization potential (Ie1) of the carrier blocking layer and the ionization potential (Ih1) of the host material of the first emitting layer satisfying the following relationship (1):

$$Ie1<Ih1+0.1\ (eV) \qquad (1)$$

3. The organic electroluminescence device according to claim 2, wherein the affinity level of the carrier blocking layer is smaller than the affinity level of the host material of the second emitting layer in an amount of 0.2 eV or more.

4. The organic electroluminescence device according to any one of claims 1 to 3, wherein the energy gap of the host material of the first emitting layer is smaller than the energy gap of the host material the second emitting layer in an amount of 0.4 eV or more.

5. The organic electroluminescence device according to claim 1, wherein the dopant of the first emitting layer is a red dopant and the dopant of the second emitting layer is a blue dopant.

6. The organic electroluminescence device according to claim 2 or 3, wherein the dopant of the first emitting layer is a red dopant and the dopant of the second emitting layer is a blue dopant, and the dopant of the third emitting layer is a green dopant.

7. The organic electroluminescence device according to any one of claims 1 to 6, wherein the carrier blocking layer includes an emitting material.

8. The organic electroluminescence device according to claim 7, wherein the emitting material of the carrier blacking layer is a green dopant.

9. The organic electroluminescence device according to any one of claims 1 to 8, further comprising a hole transporting layer adjacent to the first emitting layer between the anode and the first emitting layer.

10. The organic electroluminescence device according to claim 9, wherein a material forming the hole transporting layer is the same as a material forming the carrier blocking layer.

11. The organic electroluminescence device according to any one of claims 1 to 10, wherein the first emitting layer or a first organic layer which is the organic layer closer to the anode comprises an oxidizing agent and/or the second emitting layer or a second organic layer which is the organic layer closer to the cathode comprises a reducing agent.

12. An organic electroluminescence device according to any one of claims 1 to 11, wherein the host material of the first emitting layer is a compound represented by the following formula (1), and a dopant of the first emitting layer is a compound containing a fluoranthene skeleton or a perylene skeleton;

$$X-(Y)_n \qquad (1)$$

wherein X is a condensed aromatic ring group with 3 or more carbocycles,

Y is a group selected from a substituted or unsubstituted aryl group, a substituted or unsubstituted diarylamino group, a substituted or unsubstituted arylalkyl group and a substituted or unsubstituted alkyl group, and n is an integer of 1 to 6, provided that Ys may be the same or different when n is 2 or more.

**13.** The organic electroluminescence device according to claim 12, wherein the compound containing a fluoranthene skeleton or a perylene skeleton is an indenoperylene derivative of the following formula (2) or (3);

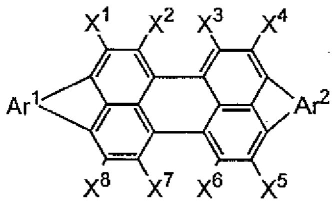

(2)

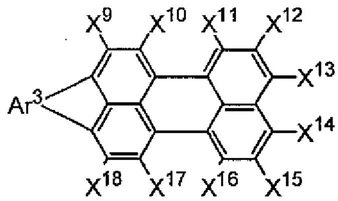

(3)

wherein $Ar^1$, $Ar^2$ and $Ar^3$ are each a substituted or unsubstituted aromatic ring group or substituted or unsubstituted aromatic heterocyclic group; $X^1$ to $X^{18}$ are each a hydrogen atom, halogen atom, alkyl group, alkoxy group, alkylthio group, alkenyl group, alkenyloxy group, alkenylthio group, aromatic-ring-containing alkyl group, aromatic-ring-containing alkyloxy group, aromatic-ring-containing alkylthio group, aromatic ring group, aromatic heterocyclic group, aromatic ring oxy group, aromatic ring thio group, aromatic ring alkenyl group, alkenyl aromatic ring group, amino group, carbazolyl group, cyano group, hydroxyl group, -$COOR^{1'}$ ($R^{1'}$ is a hydrogen atom, alkyl group, alkenyl group, aromatic-ring-containing alkyl group, or aromatic ring group), -$COR^{2'}$ ($R^{2'}$ is a hydrogen atom, alkyl group, alkenyl group, aromatic-ring-containing alkyl group, aromatic ring group or amino group) or -$OCOR^{3'}$ ($R^{3'}$ is an alkyl group, alkenyl group, aromatic-ring-containing alkyl group or aromatic ring group); and adjacent groups of $X^1$ to $x^{18}$ may be bonded to each other to form a ring with a substituted carbon atom.

**14.** The organic electroluminescence device according to claim 13, wherein the indenoperylene derivative is a dibenzotetraphenylperiflanthene derivative.

**15.** The organic electroluminescence device according to any one of claims 12 to 14, wherein the number of condensed rings in the host material of the first emitting layer is 4 or more and the number of condensed rings in the host material of the second emitting layer is 3 or less.

**16.** The organic electroluminescence device according to any one of claims 12 to 15, wherein the compound of the formula (1) is a naphthacene derivative of the following formula (4);

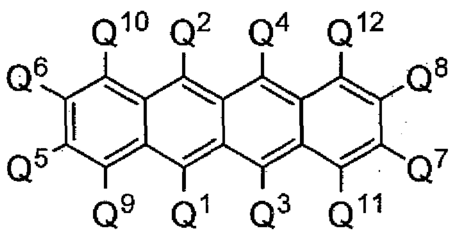

(4)

wherein $Q^1$ to $Q^{12}$, which may be the same or different, are independently a hydrogen atom, a substituted or unsubstituted alkyl group having 1 to 20 carbon atoms, a substituted or unsubstituted aryl group having 6 to 20 carbon atoms that form a ring, an amino group, a substituted or unsubstituted alkoxy group having 1 to 20 carbon atoms, a substituted or unsubstituted alkylthio group having 1 to 20 carbon atoms, a substituted or unsubstituted aryloxy group having 6 to 20 carbon atoms that form a ring, a substituted or unsubstituted arylthio group having 6 to 20 carbon atoms that form a ring, a substituted or unsubstituted alkenyl group having 2 to 20 carbon atoms, a substituted or unsubstituted aralkyl group having 7 to 20 carbon atoms that form a ring or a substituted or unsubstituted heterocyclic group having 5 to 20 atoms that form a ring.

**17.** The organic electroluminescence device according to claim 16, wherein at least one of $Q^1$, $Q^2$ , $Q^3$ and $Q^4$ in the naphthacene derivative of formula (4) is an aryl group.

**18.** The organic electroluminescence device according to claim 17, wherein the naphthacene derivative of formula (4) is represented by the following formula (5):

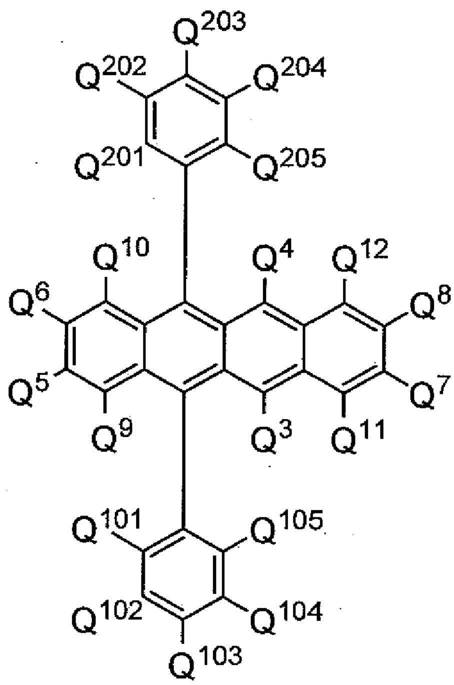

(5)

wherein $Q^3$ to $Q^{12}$, $Q^{101}$ to $Q^{105}$, and $Q^{201}$ to $Q^{205}$, which may be the same or different, are independently the same groups as those mentioned for $Q^3$ to $Q^{12}$ in said formula (1), and adjacent two or more thereof may be bonded to each other to form a ring.

**19.** The organic electroluminescence device according to claim 18, wherein at least one of $Q^{101}$, $Q^{105}$, $Q^{201}$ and $Q^{205}$ of the napthacene derivative of the formula (5) is an alkyl group, an aryl group, an amino group, an alkoxy group, an aryloxy group, an alkylthio group, an arylthio group, an alkenyl group, an aralykyl group or a heterocyclic group, which may be the same or different.

**20.** The organic electroluminescence device according to any one of claims 12 to 19, wherein the carrier blocking layer contains a tertiary amine compound, a carbazole derivative, a nitrogen-containing heterocyclic group or a metal complex.

**21.** A full-color emitting apparatus comprising the organic electroluminescence device according to any one of claims 1 to 20 that emits white light and a color filter.

FIG. 1

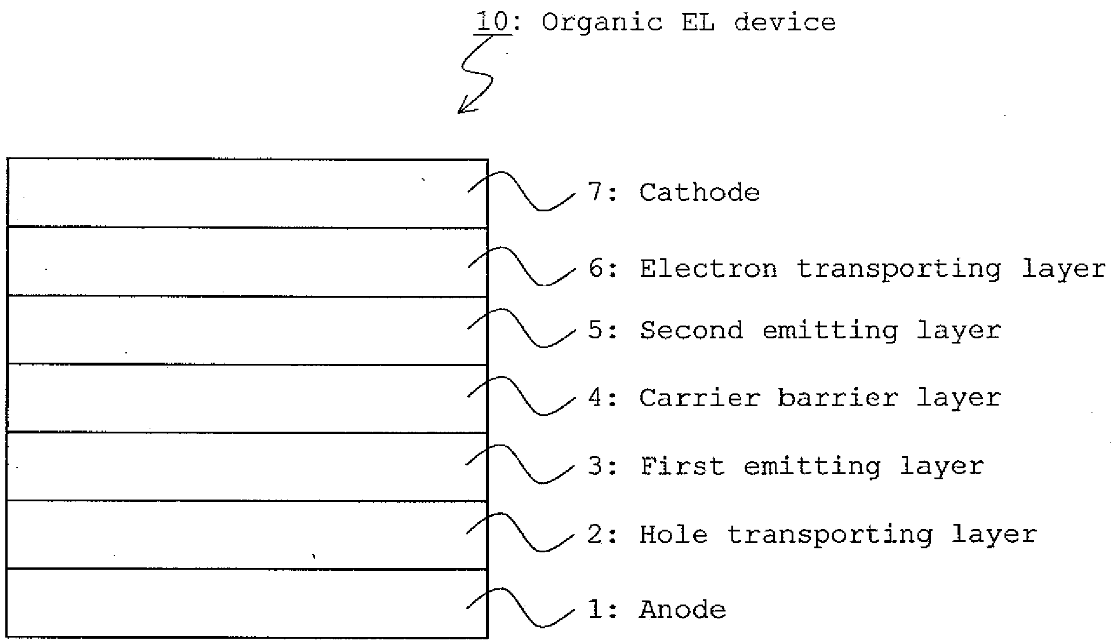
10: Organic EL device
7: Cathode
6: Electron transporting layer
5: Second emitting layer
4: Carrier barrier layer
3: First emitting layer
2: Hole transporting layer
1: Anode

FIG. 2

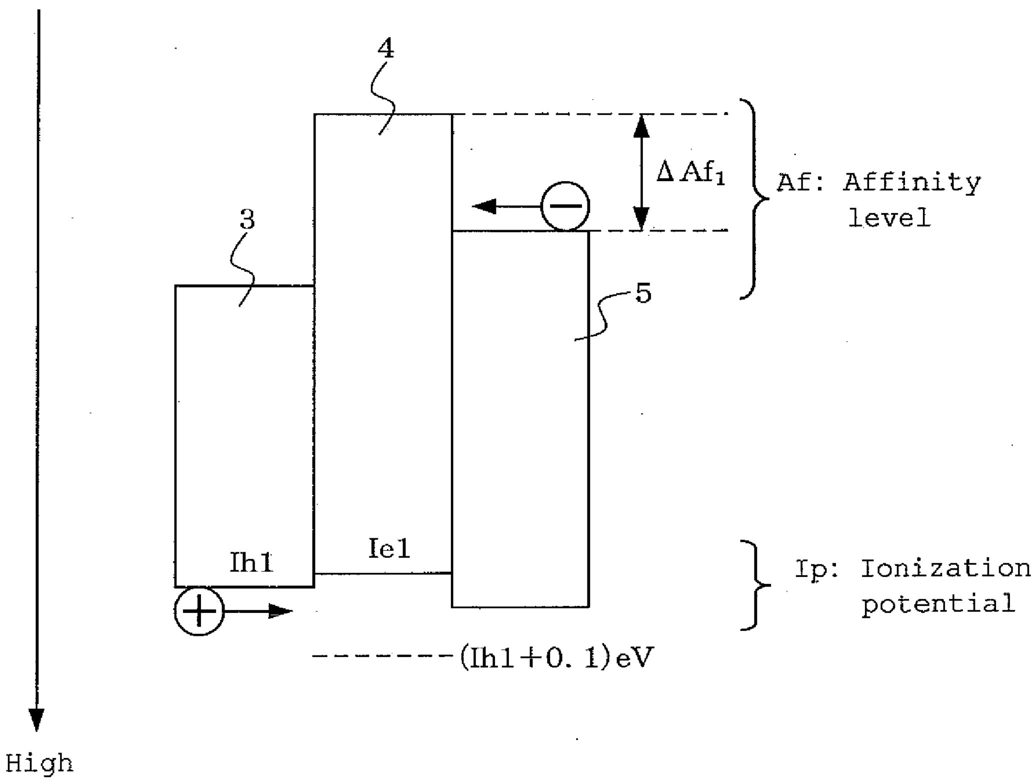
4
3
ΔAf1
Af: Affinity level
5
Ih1
Ie1
Ip: Ionization potential
(Ih1+0. 1)eV
High

FIG. 3

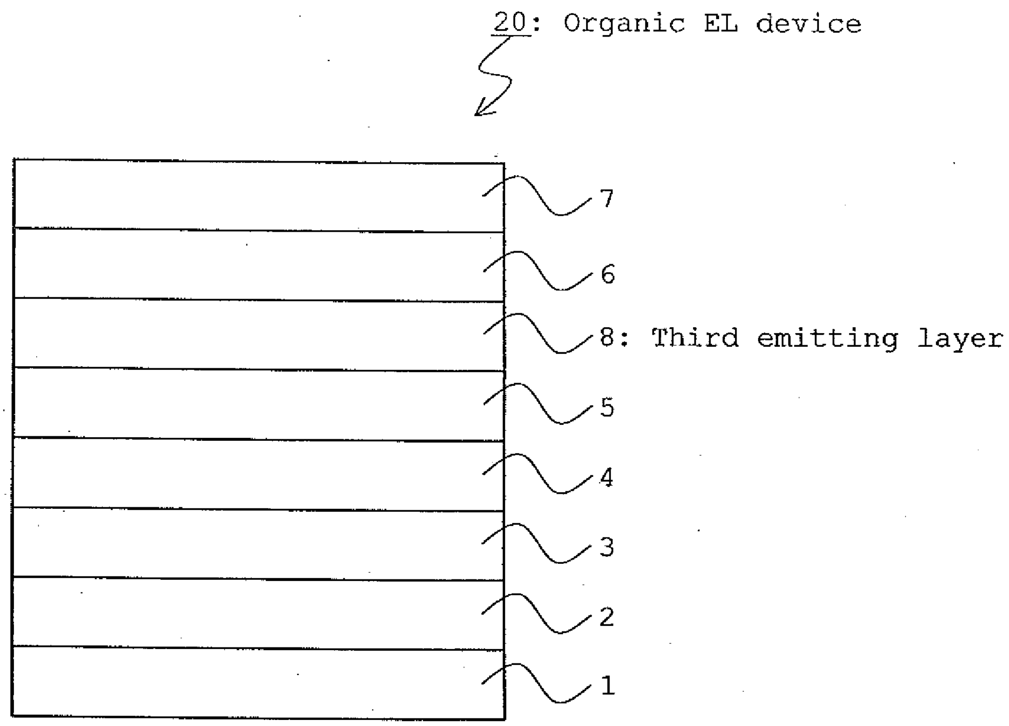
20: Organic EL device
7
6
8: Third emitting layer
5
4
3
2
1

FIG. 4

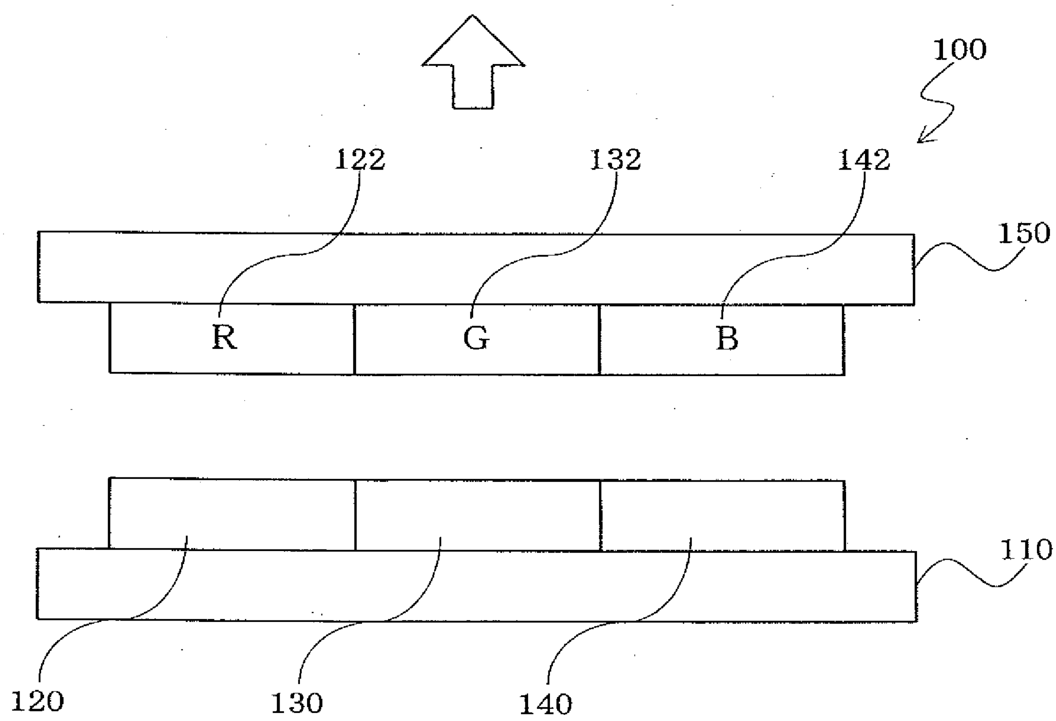
100
122
132
142
150
R
G
B
110
120
130
140

FIG. 5

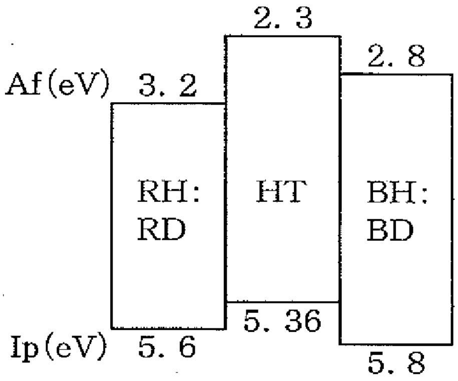


FIG. 6

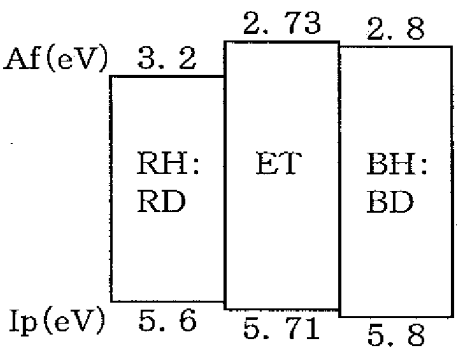


FIG. 7

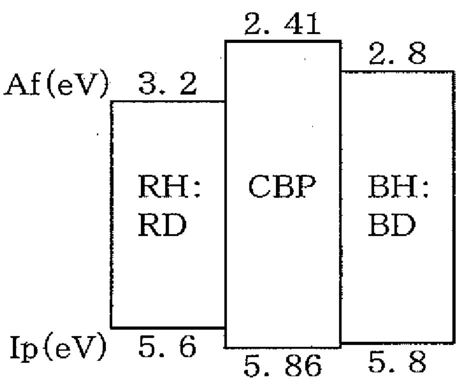

FIG. 8

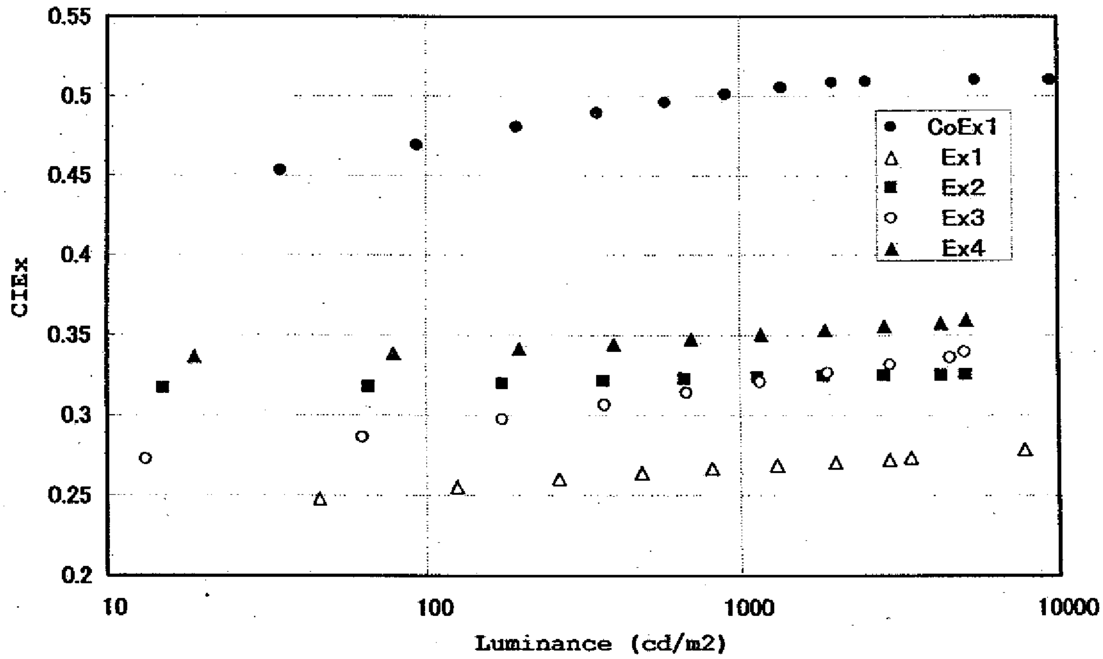


Ex: Example
CoEx: Comparative Example

FIG. 9

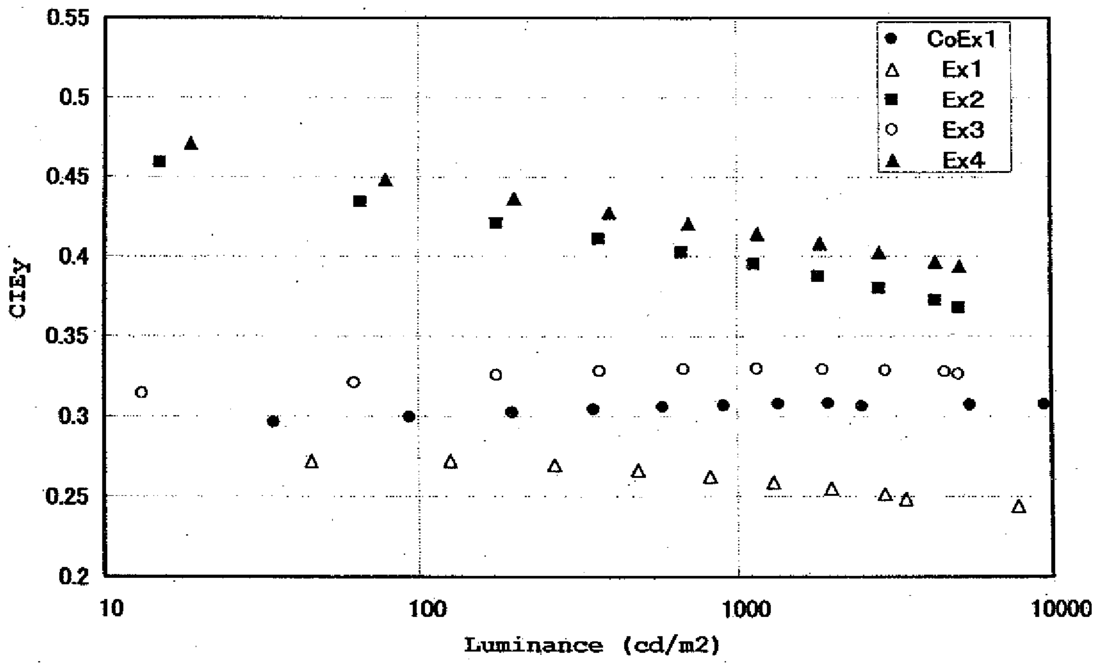


Ex: Example
CoEx: Comparative Example

## INTERNATIONAL SEARCH REPORT

International application No.
PCT/JP2007/060345

A. CLASSIFICATION OF SUBJECT MATTER
*H01L51/50*(2006.01)i, *H05B33/12*(2006.01)i

According to International Patent Classification (IPC) or to both national classification and IPC

B. FIELDS SEARCHED

Minimum documentation searched (classification system followed by classification symbols)
H01L51/50, H05B33/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)
JSTPlus(JDream2)

C. DOCUMENTS CONSIDERED TO BE RELEVANT

| Category* | Citation of document, with indication, where appropriate, of the relevant passages | Relevant to claim No. |
|---|---|---|
| A | JP 8-78163 A (Chemipro Kasei Kaisha, Ltd.), 22 March, 1996 (22.03.96), Full text; all drawings (Family: none) | 1-21 |
| A | WO 2005/099313 A1 (Idemitsu Kosan Co., Ltd.), 24 March, 2005 (24.03.05), Full text; all drawings (Family: none) | 1-21 |
| A | WO 2005/112518 A1 (Idemitsu Kosan Co., Ltd.), 15 March, 2005 (15.03.05), Full text; all drawings (Family: none) | 1-21 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 July, 2007 (17.07.07) | 24 July, 2007 (24.07.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2007/060345

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-276583 A (Idemitsu Kosan Co., Ltd.), 06 October, 2005 (06.10.05), Full text; all drawings & WO 2005/091685 A1 | 1-21 |
| A | WO 2004/060027 A1 (Fuji Photo Film Co., Ltd.), 15 July, 2004 (15.07.04), Full text; all drawings (Family: none) | 1-21 |
| A | JP 2005-150081 A (Pentax Corp., Yugen Kaisha Aitishi), 09 June, 2005 (09.06.05), Full text; all drawings (Family: none) | 1-21 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003272857 A
- JP 2004235168 A
- JP 8078163 A
- WO 2005099313 A
- WO 2005112518 A
- JP 2005100921 A
- US 20060088729 A
- US 3112197 A
- US 3189447 A
- JP 3716096 B
- US 3615402 A
- US 3820989 A
- US 3542544 A
- JP 45555 B
- JP 51010983 B
- JP 51093224 A
- JP 55017105 A
- JP 56004148 A
- JP 55108667 A
- JP 55156953 A
- JP 56036656 A
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54053435 A
- JP 54110536 A
- JP 54119925 A
- US 3567450 A
- US 3180703 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 56046234 A
- JP 54110837 A
- US 3717462 A
- JP 54059143 A
- JP 55052063 A
- JP 55052064 A
- JP 55046760 A
- JP 55085495 A
- JP 57011350 A
- JP 57148749 A
- JP 2311591 A
- JP 61210363 A
- JP 61228451 A
- JP 61014642 A
- JP 61072255 A
- JP 62047646 A
- JP 62036674 A
- JP 62010652 A
- JP 62030255 A
- JP 60093455 A
- JP 60094462 A
- JP 60174749 A
- JP 60175052 A
- US 4950950 A
- JP 2204996 A
- JP 2282263 A
- JP 1211399 A
- JP 632956965 A
- US 4127412 A
- JP 53027033 A
- JP 54058445 A
- JP 54149634 A
- JP 54064299 A
- JP 55079450 A
- JP 61295558 A
- JP 61098353 A
- JP 63295695 A
- US 5061569 A
- JP 4308688 A
- JP 8193191 A
- JP 9003448 A
- JP 2000173774 A